# EUROPEAN PATENT APPLICATION

(11) **EP 4 311 107 A1**
(43) Date of publication of application: **24.01.2024**
(21) Application number: 23744032.6
(22) Date of filing: 07.06.2023
(51) Int. Cl.: H03F 3/24, H03F 1/02, H01Q 1/24, H04B 1/40

(54) **ELECTRONIC DEVICE INCLUDING DIODE CONNECTED TO SIGNAL PATH BETWEEN RADIO FREQUENCY INTEGRATED CIRCUIT AND POWER AMPLIFIER, AND SIGNAL PATH BETWEEN CONTROLLER AND POWER SUPPLIER**

(30) Priority: 10.06.2022 KR 20220071048; 16.08.2022 KR 20220102163
(71) Applicant: Samsung Electronics Co., Ltd., Suwon-si, Gyeonggi-do 16677 (KR)
(72) Inventor: SEONG, Kihyug, Suwon-si, Gyeonggi-do 16677 (KR); YANG, Dongil, Suwon-si, Gyeonggi-do 16677 (KR); GO, Yonglim, Suwon-si, Gyeonggi-do 16677 (KR); NA, Hyoseok, Suwon-si, Gyeonggi-do 16677 (KR); MOON, Yohan, Suwon-si, Gyeonggi-do 16677 (KR)
(74) Representative: Nederlandsch Octrooibureau
(86) International application number: PCT/KR2023/007790
(87) International publication number: WO 2023/239163

(57) **Abstract**

An electronic device includes a radio frequency integrated circuit (RFIC), a power amplifier connected to the RFIC via a first signal path, a power supply for applying a voltage to the power amplifier, a controller connected to the power supply via a second signal path different from the first signal path, and a diode including an anode connected to the first signal path and a cathode connected to the second signal path. The RFIC is configured to transmit a radio signal in a radio frequency band through the first signal path to the power amplifier. The power supply is configured to apply a voltage for amplifying amplitude of the radio signal to the power amplifier. Various other embodiments are possible.

## Description

### [Technical Field]

The disclosure relates to an electronic device including at least one diode connected to a signal path between a radio frequency integrated circuit (RFIC) and an amplifier, and a signal path between a controller and a power supply.

### [Background Art]

An electronic device amplifies a signal transmitted from an RFIC through an amplifier to radiate it to the outside. The electronic device may regulate amplitude (or strength) of a voltage applied from a power supply to an amplifier based on a signal transmitted from a controller (e.g., a mobile industry processor interface (MIPI)).

### [Disclosure]

### [Technical Solution]

According to an embodiment, an electronic device includes a radio frequency integrated circuit (RFIC), a power amplifier connected to the RFIC via a first signal path, a power supply for applying a voltage to the power amplifier, a controller connected to the power supply via a second signal path different from the first signal path, and at least one diode including an anode connected to the first signal path and a cathode connected to the second signal path. The RFIC may be configured to transmit a radio signal in a radio frequency band through the first signal path to the power amplifier. The power supply may apply a voltage for amplifying amplitude of the radio signal to the power amplifier.

According to an embodiment, an electronic device includes a radio frequency integrated circuit (RFIC), a power amplifier connected to the RFIC via a first signal path, a power supply for applying a voltage to the power amplifier, a controller connected to the power supply via a second signal path different from the first signal path, an antenna connected to the power amplifier via a third signal path, and at least one diode including a cathode connected to the second signal path and an anode connected to the third signal path.

### [Description of the Drawings]

FIG. 1 illustrates a block diagram of an electronic device in a network environment according to an embodiment;
FIGS. 2A and 2B each illustrate a block diagram of an electronic device according to an embodiment;
FIGS. 3A, 3B and 3C each illustrate an example of a circuit diagram of a radio frequency front end (RFFE) in an electronic device according to an embodiment;
FIGS. 4A, 4B and 4C each illustrate an example of a circuit diagram of a portion of an RFFE in an electronic device according to an embodiment;
FIGS. 5A, 5B and 5C each illustrate an example of a circuit diagram of a portion of an RFFE in an electronic device according to an embodiment;
FIG. 6 illustrates an example of a circuit diagram of a portion of an RFFE in an electronic device according to an embodiment;
FIGS. 7A, 7B and 7C each illustrate an example of a circuit diagram of a portion of an RFFE in an electronic device according to an embodiment;
FIGS. 8A, 8B and 8C each illustrate an example of a circuit diagram of a portion of an RFFE in an electronic device according to an embodiment;
FIGS. 9A, 9B and 9C each illustrate an example of a circuit diagram of a portion of an RFFE in an electronic device according to an embodiment 9; and
FIG. 10 illustrates an example of a circuit diagram of a portion of an RFFE in an electronic device according to an embodiment.

### [Mode for Invention]

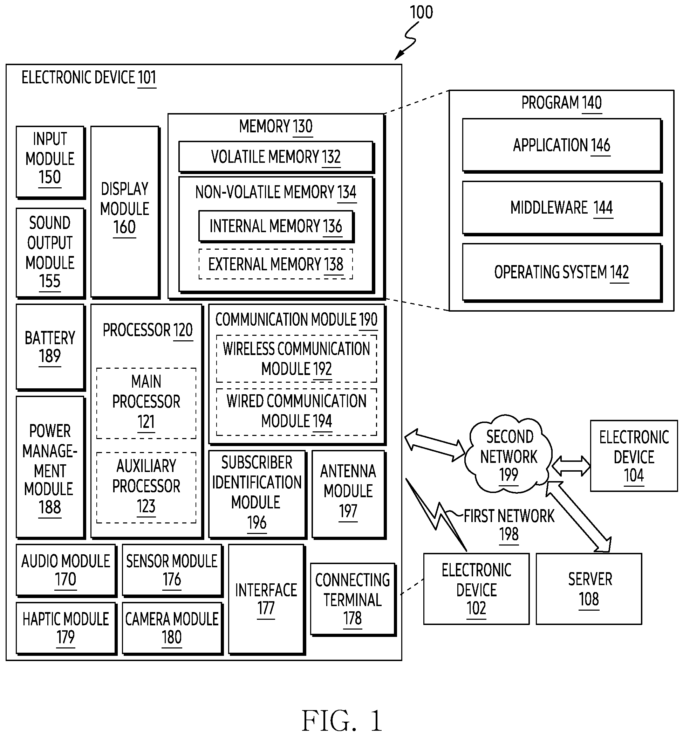

FIG. 1 illustrates a block diagram of an electronic device 101 in a network environment 100 according to an embodiment of the disclosure.

Referring to FIG. 1, an electronic device 101 in a network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, a memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module (SIM) 196, or an antenna module 197. In some embodiments of the disclosure, at least one of the components (e.g., the connecting terminal 178) may be omitted from the electronic device 101, or one or more other components may be added in the electronic device 101. In some embodiments of the disclosure, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to an embodiment, as at least part of the data processing or computation, the processor 120 may store a command or data received from another component (e.g., the sensor module 176 or the communication module 190) in a volatile memory 132, process the command or the data stored in the volatile memory 132, and store resulting data in a non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted Boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wired) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wired) or wirelessly. According to an embodiment, the interface 177 may include, for example, a high-definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, a HDMI connector, a USB connector, a SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to an embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as Bluetooth^{™}, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mm Wave band) to address, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large-scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element including a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment of the disclosure, the external electronic device 104 may include an internet-of things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

The electronic device according to various embodiments of the disclosure may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the disclosure and the terms used therein are not intended to limit the technological features set forth herein to particular embodiments and include various changes, equivalents, or replacements for a corresponding embodiment of the disclosure. With regard to the description of the drawings, similar reference numerals may be used to refer to similar or related elements. As used herein, each of such phrases as "A or B", "at least one of A and B", "at least one of A or B", "A, B, or C", "at least one of A, B, and C", and "at least one of A, B, or C" may include any one of, or all possible combinations of the items enumerated together in a corresponding one of the phrases. As used herein, such terms as "1st" and "2nd", or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with", "coupled to", "connected with", or "connected to" another element (e.g., a second element), it means that the element may be coupled with the other element directly (e.g., wired), wirelessly, or via a third element.

As used herein, the term "module" may include a unit implemented in hardware, software, or firmware, and may interchangeably be used with other terms, for example, "logic", "logic block", "part", or "circuitry". A module may be a single integral component, or a minimum unit or part thereof, adapted to perform one or more functions. For example, according to an embodiment of the disclosure, the module may be implemented in a form of an application-specific integrated circuit (ASIC).

Various embodiments as set forth herein may be implemented as software (e.g., the program 140) including one or more instructions that are stored in a storage medium (e.g., an internal memory 136 or an external memory 138) that is readable by a machine (e.g., the electronic device 101). For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a compiler or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., a compact disc read only memory (CD-ROM)), or be distributed (e.g., downloaded or uploaded) online via an application store (e.g., PlayStore^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

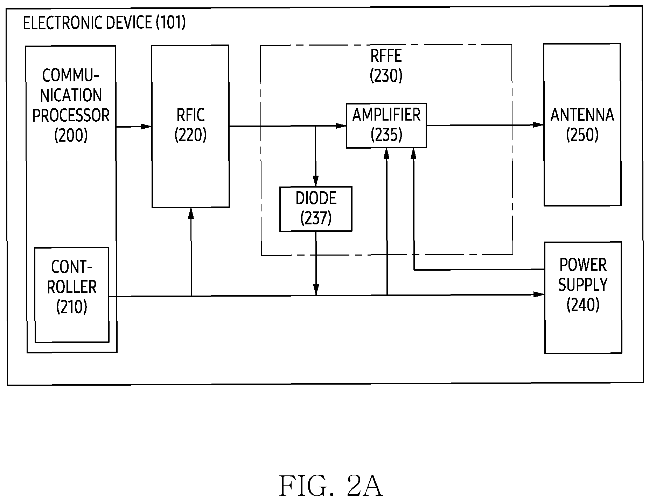

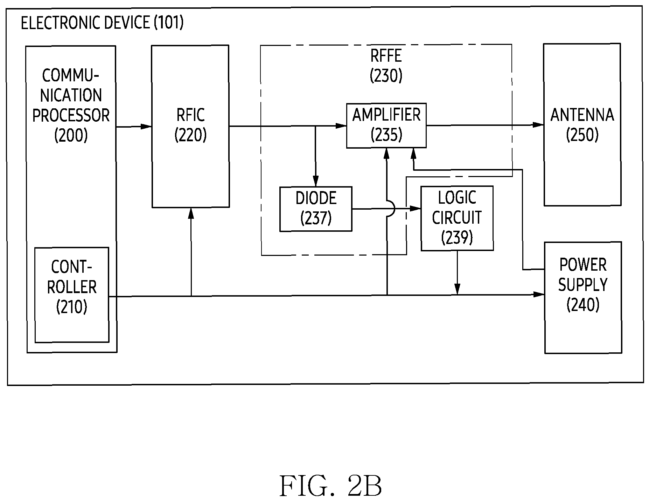

FIGS. 2A to 2B each illustrate a block diagram of an electronic device according to an embodiment. An electronic device 101 of FIGS. 2A and 2B may include the electronic device 101 of FIG. 1.

Referring to FIGS. 2A and 2B, an electronic device 101 according to an embodiment includes electronic component such as, e.g., a communication processor 200 (communication processor), a controller 210, a radio frequency integrated circuit (RFIC) 220, a radio frequency front end (RFFE) 230, an amplifier 235, at least one diode 237, a logic circuit 239, a power supply 240, and antenna 250, some of which may be electrically and/or operably coupled with each other. Although they are shown based on different blocks, the embodiment is not limited thereto. For example, some of hardware components shown in FIGS. 2A and 2B (e.g., at least one or more of the communication processor 200, the controller 210, the RFIC 220, the RFFE 230, the power supply 240, and/or the antenna 250) may be included in a single integrated circuit such as a system-on-chip (SoC). The type and/or number of the hardware components included in the electronic device 101 are not limited to those shown in FIGS. 2A and 2B. For example, the electronic device 101 may include only some of the hardware components shown in FIGS. 2A and 2B.

According to an embodiment, the communication processor 200 of the electronic device 101 may correspond to at least a part of the auxiliary processor 123 of FIG. 1 and/or the communication module 190 of FIG. 1. For example, the communication processor 200 may be used for various radio access technologies (RATs). For example, the communication processor 200 may be include the functions for performing Bluetooth communication, Long Term Evolution (LTE) communication, 5^{th} generation (5G) mobile communication technology standard, 6^{th} generation (6G) mobile communication technology standard, Wireless fidelity (WiFi), Bluetooth low energy (BLE), Near Field Communication (NFC), and/or Wireless Local Area Network (WLAN) communication. For example, the communication processor 200 may establish a connection with an external electronic device. For example, the communication processor 200 may establish a connection with a server. The communication processor 200 may include, for example, a controller 210. The communication processor 200 may control the operation of the controller 210.

According to an embodiment, the controller 210 may transmit a clock signal to the power supply 240 and/or the RFIC 220. For example, the clock signal may include a signal indicating alternately a digital value of 0 and a digital value of 1 generated from the controller 210 at a designated period. The clock signal may be transmitted to the amplifier 235, the power supply 240 and/or the RFIC 220. The RFIC 220 may transmit a radio signal in a radio frequency band to the amplifier 235 in the RFFE 230 based on the clock signal.

According to an embodiment, the controller 210 may transmit a data signal distinct from the clock signal to the amplifier 235, the power supply 240, and/or the RFIC 220. The data signal may include signals representing a digital value of 0 and/or a signal indicating a digital value of 1. The data signal may be transmitted to various components in the electronic device 101 to cause the components to execute their functions.

For example, the controller 210 may use the clock signal to notify some of the components receiving the clock signal and the data signal of one or more timing points for sampling the data signal transmitted in parallel with the clock signal. For example, the power supply 240 may obtain the timing points to sample a digital signal from the data signal, based on repetition between a digital value of 0 and a digital value of 1 included in the clock signal. After obtaining the digital signal sampled from the data signal based on the timing points, the power supply 240 may control the amplifier 235 based on information included in the digital signal.

For example, the controller 210 may transmit a control signal for radiating a signal in a certain radio frequency band to the outside to the RFIC 220, based on the control of the communication processor 200. For example, the controller 210 may transmit a signal for regulating a voltage applied to the amplifier 235 to the power supply 240, based on the control of the communication processor 200. For example, the controller 210 may include a mobile industry processor interface (MIPI). As another example, the controller 210 may include multiple controllers, although it is shown in a singular number.

According to an embodiment, the RFIC 220 may transmit a signal. For example, the RFIC 220 may transmit a signal generated by the communication processor 200. For example, when transmitting a signal, the RFIC 220 may convert a baseband signal generated by the communication processor 200 into a radio frequency (RF) signal of about 700 MHz to about 3 GHz.

According to an embodiment, when transmitting a signal, the RFIC 220 may convert the baseband signal generated by the communication processor 200 into a Sub6 band (e.g., about 6 GHz or less) of RF signal (hereinafter, 5G sub6 RF signal). The RFIC 220 may convert a pre-processed 5G Sub6 RF signal into the baseband signal to be processed by the communication processor 200.

According to an embodiment, when transmitting a signal, the RFIC 220 may convert the baseband signal generated by the communication processor 200 into a 5G Above6 band (e.g., about 6 GHz to about 60 GHz) of RF signal (hereinafter, 5G Above6 RF signal below). For example, the RFIC 220 may include an amplifier, a transmitter, a receiver, or a synthesizer, but it is not limited thereto.

According to an embodiment, the RFIC 220 may include a transmitting- end and a receiving-end. For example, the RFIC 220 may transmit a radio signal to be radiated to the outside, to the amplifier 235 included in the RFFE 230 through a transmitting-end. The RFIC 220 may receive a signal received from the outside via the antenna 250 through a receiving end. The RFIC 220 may include multiple RFICs, although it is shown in singular.

According to an embodiment, referring to FIG. 2B, the RFFE 230 may include an amplifier 235, a diode 237, and/or a logic circuit 239. According to an embodiment, the RFFE 230 may receive a signal transmitted from an external electronic device through the antenna 250 to perform pre-processing of the same. According to an embodiment, the RFFE 230 may pre-process the signal transmitted from the RFIC 220 to radiate the signal to the outside through the antenna 250. The RFFE 230 may include multiple RFFEs, although it is shown in singular. According to an embodiment, the RFFE 230 may transmit a signal transmitted from the RFIC 220 through a diode 237 via a signal path coupled to the controller 210, the RFIC 220, and/or the power supply 240, with a voltage signal regulated to be higher than a designated voltage. For example, the RFIC 220 may receive a signal passed through the diode 237. The RFIC 220 may regulate an amplitude of the signal transmitted to the RFFE 230, based on reception of the signal passed through the diode 237. For example, the RFIC 220 may transmit a signal in a radio frequency band with a voltage range that does not cause any damage to the amplifier 235, based on reception of the signal. For example, the power supply 240 may maintain a voltage applied to the amplifier 235, by the signal passing through the diode 237. For example, the power supply 240 may stop transmitting the signal to the amplifier 235 by means of the signal passing through the diode 237.

According to an embodiment, the amplifier 235 may regulate a level of the signal transmitted from the RFIC 220. For example, the amplifier 235 may amplify the signal transmitted from RFIC 220. For example, the amplifier 235 may include a power input terminal. The power input terminal of the amplifier 235 may be connected to the power supply 240. A voltage may be applied to the amplifier 235 from the power supply 240 through the power input terminal. For example, the amplifier 235 may be controlled based on the voltage applied from the power supply 240. For example, the voltage applied from the power supply 240 may cause the signal transmitted from the RFIC 220 to the amplifier 235 to be amplified in its magnitude. For example, the amplifier 235 may add the voltage applied from the power supply 240 to the radio frequency band of signal transmitted from the RFIC 220, thereby amplifying the radio frequency band of signal transmitted from the RFIC 220. The radio frequency band signal amplified by the amplifier 235 may be radiated to the outside through the antenna 250. For example, the amplifier 235 may amplify the signal transmitted from the RFIC 220 to transmit the same to the antenna 250, based on applying of the designated voltage from the power supply 240.

According to an embodiment, the amplifier 235 may include a controller different from the controller 210. A controller included in the amplifier 235 may receive a clock signal and/or a data signal transmitted from the controller 210. The operation of the amplifier 235 may be controlled, based on the clock signal and/or the data signal transmitted to the controller included in the amplifier 235 (or a controller included in the RFFE 230).

According to an embodiment, the controller of the amplifier 235 may stop its operating, based on receiving signals passing through the diode 237. For example, the controller of amplifier 235 may not amplify the signal transmitted from RFIC 220, based on receiving a signal passing through the diode 237, exceeding a designated voltage. According to an embodiment, the controller of the amplifier 235 may perform an operation while the signals pass through the diode 237, based on receiving the signals passing through the diode 237. For example, in response to receiving the signal passing through the diode 237, the controller of the amplifier 235 may perform an operation immediately before receiving the signal.

According to an embodiment, the amplifier 235 may regulate a gain between a signal transmitted from the RFIC 220 and a signal to be transmitted from the amplifier 235 to the antenna 250. The gain may refer to a power ratio between the signal transmitted from the RFIC 220 and the signal transmitted to the antenna 250. As the gain is more increased, the amplifier 235 may amplify the signal transmitted from the RFIC 220 to the amplifier 235 more.

According to an embodiment, the diode 237 may be connected to a signal path between the RFIC 220 and the amplifier 235 and a signal path between the controller 210 and the power supply 240. For example, the diode 237 may include an anode coupled in the signal path between RFIC 220 and amplifier 235. The diode 237may include a cathode coupled to the signal path between the controller 210 and the power supply 240. The cathode of the diode 237 may be connected to a resistor (not shown) to prevent damage to the diode 237.

Referring to FIG. 2A, the flow of current from the anode to the cathode of the diode 237 may be generated based on the voltage between the anode and the cathode exceeding a designated voltage (e.g., about 0.7V). For example, the diode 237 may transmit a signal no less than a designated voltage (e.g., about 0.7V) and/or a designated power (e.g., about 7 dBm) from the signal path between the RFIC 220 and the amplifier 235 to the signal path between the controller 210 and the power supply 240.

According to an embodiment, the signal transmitted through the signal path between the controller 210 and the power supply 240 may be added to other signal (e.g., clock signal, and/or data signal) transmitted through the signal path between the controller 210 and the power supply 240. Such addition of the signal and the other signal may distort information contained in the other signal (e.g., periodicity of clock signal, and/or address contained in the data signal).

For example, controlling of the power supply 240 based on the signal path between the controller 210 and the power supply 240 may be ceased due to the distortion. Since the power supply 240 ceases to be controlled by the signal received from the controller 210 (e.g., the clock signal, and/or the data signal), supplying of the power or voltage for the amplifier 235 by power supply 240 may be interrupted. Thus, the interruption of supplying the power to the amplifier 235 may cause the amplifier 235 to cease signal amplification. For example, the amplifier 235 may be deactivated by a signal sent to power supply 240 via diode 237.

For example, the controller 210 and the power supply 240 of which control is ceased due to the distortion may perform an operation before the control is ceased by the amplifier 235.

As described above, the clock signal transmitted from the controller 210 to the power supply 240 and/or the data signal may be distorted by the signal of a designated voltage and/or power or more, transmitted from the RFIC 220 to the diode 237. For example, the signal of a designated voltage or higher transmitted from the RFIC 220 to the amplifier 235 may be transmitted to the signal path between the controller 210 and the power supply 240, and may be added to the signal transmitted from the controller 210 to the power supply 240. Controlling of the power supply 240 by the controller 210 may be hindered by the addition of the signals. For example, the possibility of damage to the amplifier 235 may increase as the strength of the signal input to the amplifier 235 (e.g., the signal transmitted from the RFIC 220) increases. When the amplifier 235 amplifies a relatively large signal, the possibility of damage to the amplifier 235 may increase as an overload of the amplifier 235 occurs. According to an embodiment, the electronic device 101 may operate to distort other signal for driving the amplifier 235 based on the strength of the signal input to the amplifier 235. For example, the other signal for driving the amplifier 235 may include the clock signal transmitted from the controller 210 to the power supply 240 of the amplifier 235, and/or the data signal. The electronic device 101 may conditionally add the signal input to the amplifier 235 to the other signal for driving the amplifier 235, using the diode 237. For example, when the signal input to the amplifier 235 exceeds a designated strength, the signal input to the amplifier 235 may be combined, by the diode 237, to the clock signal, which is transmitted to the power supply 240, and/or the data signal. Because the signal input to the amplifier 235 is coupled to the clock signal and/or the data signal, the information sent to the power supply 240 to drive the amplifier 235 may be distorted. Since the controlling of the power supply 240 is ceased by the distortion of the information, driving of the amplifier 235 connected to the power supply 240 may be stopped at least temporarily. For example, when a signal exceeding the designated strength is input to the amplifier 235, driving of the amplifier 235 may be stopped. As driving of the amplifier 235 is stopped by the signal exceeding the designated strength, the possibility of damaging to the amplifier 235 can decrease.

For example, a signal exceeding the designated voltage and/or power transmitted from the RFIC 220 may cause damage (or burn-out) to the amplifier 235. The signal above the designated voltage and/or designated power passing through diode 237 may be transmitted to the signal path between the controller 210 and the power supply 240 to control operation of the RFIC 220 and/or the power supply 240. For example, the RFIC 220 may be caused to cease from sending a signal to the RFFE 230, by receiving a signal through diode 237. For example, the power supply 240 may be ceased from sending the voltage it applies to amplifier 235, by receiving a signal through the diode 237. For example, the RFIC 220 and/or the power supply 240 may transmit the same signal as the signal being transmitted, as the control of the controller 210 is interrupted by the diode 237.

Referring to FIG. 2A, according to an embodiment, the diode 237 may be electrically connected to the signal path between the controller 210 and the power supply 240 and a signal path between the RFIC 220 and the amplifier 235. According to an embodiment, the diode 237 may transmit at least a portion of the signal transmitted from the RFIC 220 to the signal path between the controller 210 and the power supply 240, when the signal transmitted from the RFIC 220 is equal to or greater than a designated level. The signals delivered via diode 237 may interrupt the control of the RFIC 220, the amplifier 235, and/or the power supply 240. For example, the signal transmitted through diode 237 may be added to the clock signal and/or the data signal transmitted from controller 210 to interrupt (or suppress) the control of the RFIC 220, the amplifier 235, and/or the power supply 240. For example, in a state that the signal passing through the diode 237 is added to a clock signal, the power supply 240 may not be able to identify sampling points of the data signal from the clock signal. In the example above, the power supply 240 may cease sampling the data signal. Because sampling of the data signal is ceased, the power supply 240 may at least temporarily cease to be controlled by the data signal. As the control of the power supply 240 is stopped, the amplification of the signal in radio frequency band by the amplifier 235 may be stopped. Since the amplification by the amplifier 235 is ceased, the amplifier 235 may not amplify the signal that exceeds the designated voltage of the diode 237. Since the amplifier 235 ceases amplifying the signal exceeding the designated voltage, it is possible to prevent occurrence of damage to the amplifier 235 due to overloading of the amplifier 235 (such as e.g., amplifying the signal exceeding the designated voltage).

For example, the diode 237 may include at least one of a silicon diode, a germanium diode, a Zener diode, a current limiting diode, an Esaki diode (or a tunnel diode), a Schottky barrier diode, a variable capacitance diode (or varactor), a selenium diode, and/or a mercury diode. However, the embodiments are not limited thereto. For example, the diode 237 may have plural diodes although it is shown in singular.

Referring to FIG. 2B, according to an embodiment, the diode 237 may be connected to a logic circuit (or logic gate) 239. For example, the logic circuit 239 may include at least one of NOT gate, OR gate, AND gate, XOR gate, NOR gate, and/or NAND gate. For example, the logic circuit 239 may include a latch and/or a flip-flop. For example, the latch may include at least one of SR NAND latch, SR NOR latch, gate SR latch, gate D latch, and/or JK latch. For example, the flip-flop may include at least one of SR flip-flop, D flip-flop, J-K flip-flop, T flip-flop, and/or A flip-flop.

According to an embodiment, the logic circuit 239 may transmit a signal to control the operation of the power supply 240 to the power supply 240, based on the signal transmitted from the controller 210 and the signal passed through the diode 237. According to an embodiment, the logic circuit 239 may transmit a signal obtained based on the signal passing through the diode 237 to the RFIC 220, so as to control the signal transmitted from the RFIC 220 to the RFFE 230.

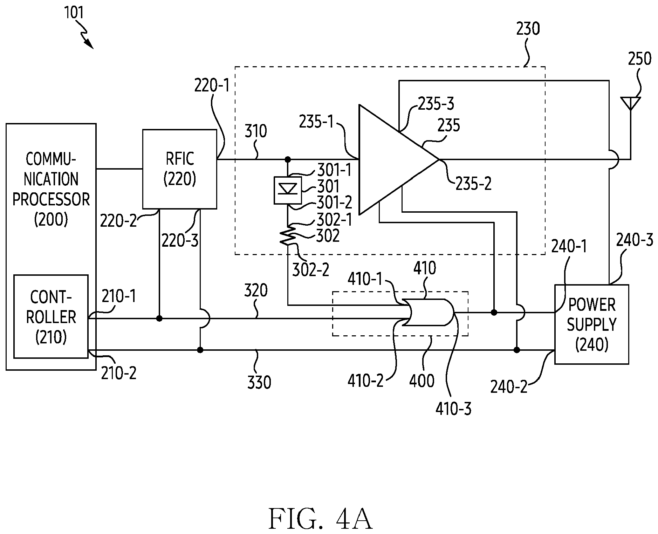

According to an embodiment, the logic circuit 239 may cause initialization (or reset) of the communication processor 200 and/or the controller 210, through a counter and/or a storage function. For example, the initialization of the controller 210 may mean operating in a state that the controller 210 initially operated. According to an embodiment, the electronic device 101 including the logic circuit 239 will be described with reference to FIGS. 4A to 5C and/or 8A to 9C. According to an embodiment, the logic circuit 239 may be omitted.

Referring back to FIGS. 2A and 2B, according to an embodiment, the power supply 240 may be connected to the amplifier 235. For example, the power supply 240 may apply a voltage to the amplifier 235 to amplify the signal transmitted from the RFIC 220. For example, the power supply 240 may apply the voltage to the amplifier 235, based on control signals transmitted from the controller 210 (e.g., a control signal (e.g., clock signal) transmitted in a designated period, and a control signal to represent data (e.g., data signal)). According to an embodiment, the power supply 240 may regulate the voltage applied to the amplifier 235, based on addition of the control signals transmitted from the controller 210 and the signal transmitted through the diode 237.

For example, the controller 210 may transmit a signal indicating a digital value of 0 while the signal is transmitted through the diode 237. The signal transmitted through diode 237 may be added to a signal indicating a digital value of zero. For example, the signal passing through the diode 237 added to the signal indicating a digital value of 0 may interfere with the control of the components included in the electronic device 101. For example, the power supply 240 may be controlled based on control signals from the controller 210. For example, the power supply 240 may be controlled based on receiving the clock signal and/or the data signal from the controller 210. The signal passing through diode 237 may be added to the signal transmitted from controller 210 and corrupt the signal for controlling the power supply 240. The power supply 240 may execute an operation different from the control of controller 210, in response to receiving the corrupted signal based on the diode 237. For example, the operation different from the control of the controller 210 may include an operation of maintaining a voltage applied to the amplifier 235. The power supply 240 can prevent overload of the amplifier 235, by means of the operation of maintaining the voltage applied to the amplifier 235. Thus, damage (or burn-out) of the amplifier 235 can be prevented owing to preventing the overload of the amplifier 235. However, the embodiments are not limited thereto. For example, the operation different from the control of the controller 210 may include ceasing supply of the voltage applied to the amplifier 235.

According to an embodiment, the antenna 250 may transmit or receive a signal or power to/from the outside (e.g., an external electronic device). According to an embodiment, the antenna 250 may include an antenna with at least one radiator including a conductor or a conductive pattern formed on a substrate (e.g., a printed circuit board (PCB)). According to an embodiment, the antenna 250 may include a plurality of antennas (e.g., an array antenna). The signal or power may be transmitted or received between the communication processor 200 and an external electronic device through the antenna 250 or at least one of the plurality of antennas. The antenna 250 of FIGS. 2A and 2B may include the antenna module 197 of FIG. 1.

When a signal is transmitted from the RFIC to the amplifier with the cathode of the diode being grounded, damage to the amplifier may be caused based on the signal transmitted from the RFIC having a level of a designated voltage and/or a designated power or higher. As described above, the electronic device 101 can control the amplifier 235, the power supply 240 and/or the RFIC 220, based on the signal transmitted to the signal path between the controller 210 and the power supply 240 through the diode 237, thereby preventing the damage (or burn-out) of the amplifier 235.

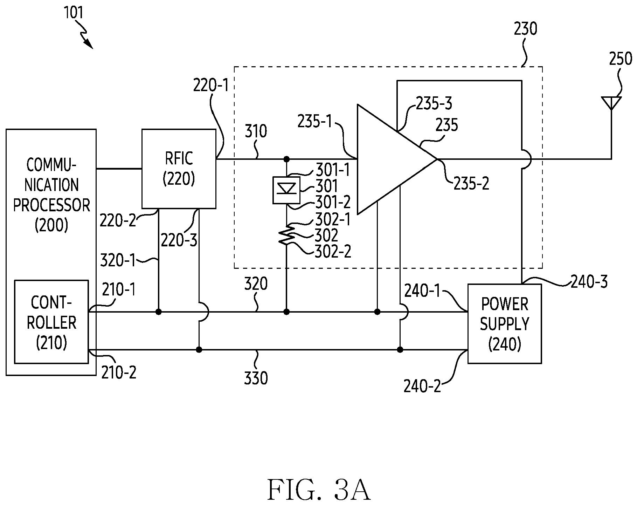

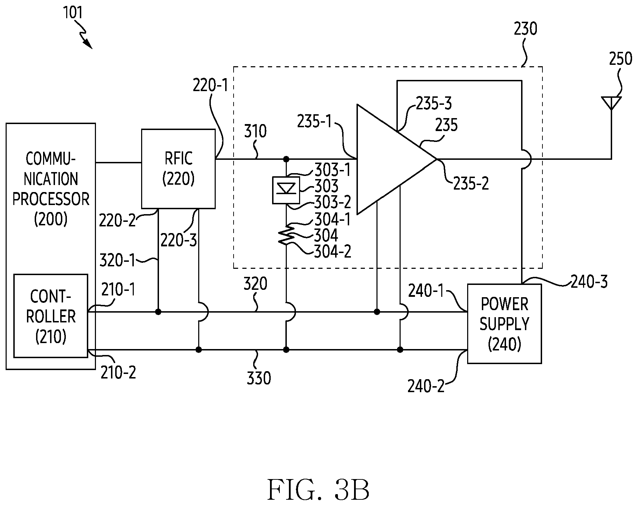

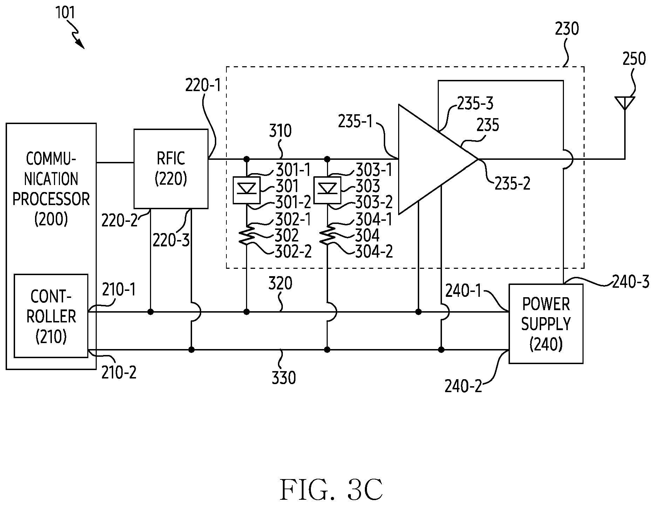

FIGS. 3A to 3C each illustrate an example of a circuit diagram of a radio frequency front end (RFFE) included in an electronic device according to an embodiment. The electronic device 101 of FIGS. 3A to 3C may be an example of the electronic device 101 of FIGS. 1 to 2B. The communication processor 200 of FIGS. 3A to 3C may be an example of the communication processor 200 of FIGS. 2A to 2B. The RFFE 230 of FIGS. 3A to 3C may be an example of the RFFE 230 of FIGS. 2A to 2B. The controller 210 of FIGS. 3A to 3C may be an example of the controller 210 of FIGS. 2A to 2B. The RFIC 220 of FIGS. 3A to 3C may be an example of the RFIC 220 of FIGS. 2A to 2B. The power supply 240 of FIGS. 3A to 3C may be an example of the power supply 240 of FIGS. 2A to 2B. The antenna 250 of FIGS. 3A to 3C may be an example of the antenna 250 of FIGS. 2A to 2B. The diode 301 of FIGS. 3A and/or 3C may be an example of the diode 237 of FIGS. 2A to 2B. The diode 303 of FIGS. 3B to 3C may be an example of the diode 237 of FIGS. 2A to 2B.

Referring to FIGS. 3A to 3C, the electronic device 101 may include a communication processor 200, a controller 210, an RFIC 220, an RFFE 230, a power supply 240, and/or an antenna 250. The RFFE 230 may further include an amplifier 235, a diode 301 and/or a diode 303.

According to an embodiment, the communication processor 200 may include a controller 210. The communication processor 200 may control the controller 210. The controller 210 may transmit, based on the control of the communication processor 200, signals for controlling the components (e.g., RFIC 220, RFFE 230, amplifier 235, and/or power supply 240) included in the electronic device 101. For example, the controller 210 may transmit clock signals and/or data signals to control the components. The communications processor 200 may be operatively coupled with the RFIC 220. The communication processor 200 may regulate a amplitude of the radio signal to be emitted from the RFIC 220 to the outside. The communication processor 200 may control the operation of the controller 210. For example, the communication processor 200 may specify the amplitude of the signal to be transmitted from the RFIC 220 to the amplifier 235.

Referring to FIG. 3A, according to an embodiment, the controller 210 may include a sending end 210-1 for transmitting the clock signal and/or a sending end 210-2 for transmitting the data signal. The sending end 210-1 of the controller 210 may be connected to the receiving end 220-2 of the RFIC 220 and the receiving end 240-1 of the power supply 240. The sending end 210-2 of the controller 210 may be connected to the receiving end 220-3 of the RFIC 220 and the receiving end 240-2 of the power supply 240.

According to an embodiment, the RFIC 220 may include a sending end 220-1. The sending end 220-1 may be connected to an input terminal 235-1 of the amplifier 235. The RFIC 220 may include a receiving end 220-2 for acquiring signals via a signal path 320 and/or a receiving end 220-3 for acquiring signals via a signal path 330. An output terminal 235-2 of the amplifier 235 may be connected to the antenna 250. The RFIC 220 may transmit a radio signal in a radio frequency band to the amplifier 235 through the signal path 310.

According to an embodiment, the receiving end 240-1 of the power supply 240 may be connected to the signal path 320. The receiving end 240-2 of the power supply 240 may be connected to the signal path 330. The power supply 240 may be conned to the signal path 320 for receiving the signal transmitted from controller 210 and/or the diode 301. The output terminal 240-3 of the power supply 240 may be connected to the power input terminal 235-3 of the amplifier 235. The power supply 240 may be connected to the power input terminal 235-3 of the amplifier 235 via the signal path for applying a voltage to the amplifier 235. The power supply 240 may regulate the voltage applied to the amplifier 235, based on the signal transmitted from the controller 210 and/or the diode 301.

According to an embodiment, the diode 301 may include an anode 301-1 and a cathode 301-2. For example, the anode 301-1 of the diode 301 may be connected to the signal path 310. The RFIC 220 may transmit a signal in the radio frequency band for radiating to the outside to the amplifier 235 through the signal path 310. The cathode 301-2 of the diode 301 may be connected to the signal path 320. The controller 210 may transmit the clock signal through signal path 320. According to an embodiment, the diode 301, based on the amplitude of the signal received through the anode 301-1 being greater than the amplitude of the signal received through the cathode 301-2, may transmit the signal from the anode 301-1 to the cathode 301-2. According to an embodiment, the diode 301, based on the amplitude of the signal received by the cathode 301-2 being greater than the amplitude of the signal received by the anode 301-1, may block the signal transmitted from the cathode 301-2 to the anode 301-1. For example, the diode 301 may transmit a signal from the signal path 310 to the signal path 320, based on identifying the signal in the radio frequency band transmitted from RFIC 220 having a magnitude greater than or equal to a designated voltage. For example, the signal transmitted from controller 210 may be added to the signal passing through the diode 301. The signal passing through the diode 301 and the signal transmitted from controller 210 may control the operation of the power supply 240. For example, the signal higher than or equal to the designated voltage may cause damage onto the clock signal input to the power supply 240. The damaged clock signal may interfere with identification of sampling timing of the data signal. For example, the amplifier 235 and/or the power supply 240 may not be able to identify sampling points of the data signal transmitted from controller 210 due to receiving the corrupted clock signal. As the data signal is not identified correctly, the amplifier 235 and/or the power supply 240 may be at least temporarily ceased to be controlled by the data signal. As the control of the amplifier 235 and/or the power supply 240 is at least temporarily suspended, the amplifier 235 may stop amplifying the signal in the radio frequency band. According to an embodiment, the amplifier 235 and/or the power supply 240 may perform an operation prior to receiving the corrupted signal while receiving the corrupted signal. For example, the amplifier 235 and/or the power supply 240 may maintain the operation prior to receiving the corrupted signal.

For example, the operation of the RFIC 220 may be controlled by a signal having the designated voltage or higher. The signal having a voltage higher than or equal to the designated voltage may include a signal transmitted to the signal path 320 through the diode 237. The signal transmitted through the signal path 320 may be added to the clock signal transmitted from the controller 210 and then transmitted to the RFIC 220 through the signal path 320-1. The signal transmitted via the signal path 320-1, being added to the clock signal may interfere with identification of the data signal by RFIC 220. For example, the RFIC 220 may not be able to identify the timing of sampling the data signal, based on receiving the signal transmitted via the signal path 320-1, being added to the clock signal. Since the RFIC 220 cannot identify the timing of sampling the data signal, it may perform an operation different from the control of the controller 210 and/or the communication processor 200.

For example, the RFIC 220 may, based on the signal having the designated voltage or higher, regulate the amplitude of the signal transmitted to the amplifier 235 within a range that the amplifier 235 does not burn out (e.g., about 7 dBm or less or a voltage of about 5.1V or less) to transmit the regulated signal. For example, the RFIC 220 may reduce the amplitude of the signal and transmit the same to the amplifier 235, based on the signal having a designated voltage or higher.

According to an embodiment, a resistor 302 may be connected to the cathode 301-2 of the diode 301. For example, the resistor 302 may include one end 302-1 connected to the cathode 301-2 of the diode 301 and the other end 302-2 connected to the signal path 320. For example, the resistor 302 may function to prevent damage to the diode 301, by regulating the voltage applied to the diode 301.

According to an embodiment, the RFIC 220 may regulate the amplitude of the radio signal to be radiated to the outside, based on the signal obtained through the signal path 320-1. For example, the RFIC 220 may regulate the amplitude of the signal transmitted from the sending end 220-1 of the RFIC 220 to the amplifier 235, based on the signal obtained by the diode 301.

The following Table 1 is to enumerate examples of various operations of the communication processor 200, the controller 210, and the RFIC 220.

**[Table 1]**

| **Case s** | **Amplitude of Radio Signal designated in Communicati on Processor** | **Signal Blockin g by Diode** | **Transmissio n of Clock Signal by Controller** | **Operatio n of Controll er** | **Amplitud e of Signal transmitt ed from RFIC** | **Contr ol of Powe r Suppl Y** |
|---|---|---|---|---|---|---|
| **1^{st} Case** | 0dBm | o | o | o | 0dBm | o |
| **2^{nd} Case** | 5dBm | o | o | o | 5dBm | o |
| **3^{rd} Case** | 6dBm | o | o | o | 6dBm | o |
| **4^{th} Case** | 7dBm | x | x | x | 6dBm | x |
| **5^{th} Cas e** | 8dBm | x | x | x | 6dBm | x |
| **6^{th} Cas e** | 6dBm | o | o | o | 6dBm | o |

Referring to the Table 1, the first to third cases and the sixth cases may refer to a normal operating state, which is indicated as a symbol "O", of the communication processor 200, the controller 210, the RFIC 220, and/or the power supply 240. For example, in a normal operating state (e.g., case 1 to case 3, and case 6), the communication processor 200 may transmit a signal (e.g., for transmission at 0 dBm, 5 dBm, and/or 6 dBm) for transmitting a designated power of radio signal to the RFIC 220. The RFIC 220 may transmit the signal (e.g., 0 dBm, 5 dBm, 6 dBm) having the designated power of radio signal to the amplifier 235. In a normal operating condition, the diode 301 may block transmission of the signal from the signal path 310 to the signal path 320. The power supply 240 may apply a voltage to the power input terminal 235-3 of the amplifier 235. The amplifier 235 may amplify the signal transmitted from the RFIC 220 and transmit the amplified signal to the antenna 250. The fourth case to the fifth case may refer to a state, which is indicated as a symbol "X", that causes damage to the amplifier 235. In the cases 4 to 5, the signal transmitted from the signal path 310 to the signal path 320 via the diode 301 may control the operation of the controller 210, the RFIC 220, and/or the power supply 240. The controller 210, the RFIC 220, the amplifier 235, and/or the power supply 240 may be controlled based on the signals transmitted from the signal path 310 to the signal path 320. For example, the fourth to fifth cases may refer to a case in which the signal having a designated power or higher (e.g., 7 dBm and/or 8 dBm) is transmitted through the signal path 310. The diode 301 may receive a signal of a designated power or more from the signal path 310 and then transmit the same to the signal path 320. In a state of the signal being transmitted to the signal path 320 through the diode 301, the operation of the controller 210 and/or the power supply 240 may be interrupted. For example, the RFIC 220 that received the signal for transmitting a radio signal having a magnitude of 7 dBm by the communication processor 200 may transmit a radio signal having a magnitude of 6 dBm, while transmitting the radio signal having a magnitude of 7 dBm, based on the signal transmitted via the signal path 320 and the signal path 320-1.

The sixth case may refer to a state that the controller 210, the RFIC 220, and/or the power supply 240 operate in a normal state, subsequently to the fifth case. For example, the sixth case may include a state that substantially the same operation as the third case is performed.

Referring to FIG. 3B, according to an embodiment, the communication processor 200 may include the controller 210. The communications processor 200 may be operatively coupled to the RFIC 220. The communication processor 200 may control the operation of the controller 210 and/or the RFIC 220. For example, the communication processor 200 may transmit, to the RFIC 220, a signal indicating amplitude of a radio signal to be radiated from the RFIC 220 to the outside. The communication processor 200 may be substantially the same as the communication processor 200 of FIGS. 2A to 3A.

According to an embodiment, the diode 303 may be connected between the signal path 310 and the signal path 330. For example, the anode 303-1 of the diode 303 may be connected to the signal path 310. For example, the cathode 303-2 of the diode 303 may be connected to the signal path 330. For example, the diode 303 may rectify a signal transmitted from the RFIC 220. For example, rectifying the signal may include converting an alternating current signal in a radio frequency band, transmitted from the RFIC 220 to the amplifier 235, into a form of direct current voltage. For example, the diode 303 may rectify the signal, transmitted from RFIC 220, having a designated voltage (e.g., 0.7V) and/or a designated power (e.g., 6.9 dBm) or higher, so as to transmit the rectified signal from the signal path 310 to the signal path 330. For example, the signal transmitted via the signal path 330 may be transmitted to the RFIC 220 via the signal path 330-1. According to an embodiment, the cathode 303-2 of the diode 303 may be connected to the resistor 304 to prevent damage to the diode 303. The resistor 304 may include one end 304-1 connected to the cathode 303-2 of the diode 303 and the other end 304-2 connected to the signal path 330.

According to an embodiment, the RFIC 220 may regulate the amplitude of the signal transmitted to the amplifier 235, based on the signal transmitted via the signal path 330-1. According to an embodiment, the power supply 240 may regulate the amplitude of the voltage applied to the amplifier 235, based on the signal transmitted via the signal path 330. For example, the power supply 240 may receive a signal obtained based on the diode 303, while the controller 210 transmits a designated period of control signal (hereinafter, referred to as a clock signal) and/or a control signal for indicating data (hereinafter, referred to as a data signal) to the power supply. For example, the power supply 240 may maintain the level of the voltage applied to amplifier 235, based on the signal obtained by diode 303.

For example, in a state of the signal passing through the diode 237 being added to the data signal, the power supply 240 may not be temporarily controlled. The power supply 240 may not be temporarily controlled, because the signal passed through the diode 237 being added to the data signal cannot be identified as a control signal. In a state of the power supply 240 being not controlled by the controller 210, the power supply 240 may apply the voltage when controlled by the controller 210 to the amplifier 235. For example, in a state of the signal passing through the diode 237 being added to the data signal, the power supply 240 may cease transmitting the voltage applied to the amplifier 235.

Referring to FIGS. 3A to 3B, when the diode 301 is connected to the signal path 320 of FIG. 3A, the control of the power supply 240 and/or the controller 210 may be relatively easy, compared to the case where the diode (303) is connected to the signal path 330 of FIG. 3B.

Referring to FIG. 3C, according to an embodiment, the RFIC 220 may transmit an AC signal to the amplifier 235 through the signal path 310, and the amplifier 235 may regulate the amplitude of the signal transmitted from the antenna 250 to transmit, to the antenna 250, the signal to be radiated to the outside therethrough.

According to an embodiment, the communication processor 200 may include the controller 210. The communications processor 200 may be operatively coupled to the RFIC 220. For example, the communication processor 200 may perform substantially the same operation as the communication processor 200 of FIGS. 2A to 3B.

According to an embodiment, the diode 301 may be connected between the signal path 310 and the signal path 320. Another diode 303 may be connected between the signal path 310 and the signal path 330. For example, the anode 301-1 of the diode 301 may be connected to the signal path 310. The cathode 301-2 of the diode 301 may be connected to the signal path 320. The anode 303-1 of the diode 303 may be connected to the signal path 310. The cathode 303-2 of the diode 303 may be connected to the signal path 330. The diodes 301 and 303 may direct the signal transmitted from RFIC 220, from the signal path 310 to the signal path 320 and/or the signal path 330, based on the signal transmitted from RFIC 220 being identified as having the designated voltage and/or the designated power or higher. The operation of the controller 210, the RFIC 220, the amplifier 235, and/or the power supply 240 may be controlled using the signal equal to or greater than the designated voltage and/or designated power. The signal equal to or greater than the designated voltage and/or designated power may cause distortion of the control signals (e.g., the clock signal and/or the data signal) transmitted from the controller 210. For example, the control signals with distortion by the signals of the designated voltage and/or the designated power or higher may cause temporary ceasing of the control of the RFIC 220, the amplifier 235, and/or the power supply 240. For example, the operation of the RFIC 220 may be controlled by a signal propagated to the signal path 320-1 based on the diode 301. For example, the amplitude of the signal transmitted from the RFIC 220 to the amplifier 235 may be regulated based on the signal. For example, the operation of the RFIC 220 may be controlled based on the signal propagated to the signal path 330-1 based on the diode 303. For example, the amplitude of the signal transmitted from the RFIC 220 to the amplifier 235 may be regulated based on the signal. For example, the diodes 301 and 303 may transmit the signal transmitted from RFIC 220 to the signal path 320 and/or the signal path 330, while the control signal is transmitted from the controller 210 to the power supply 240. The signals transmitted to the signal path 320 and/or the signal path 330 may control the RFIC 220, the amplifier 235, and/or the power supply 240. For example, the distorted control signals may be transmitted to some components (e.g., RFIC 220, amplifier 235, and/or power supply 240) so as to temporarily interrupt the operation of the components.

According to an embodiment, the diodes 301 and 303 may be connected to resistors 302 and 304, respectively. For example, the cathode 301-2 of the diode 301 may be connected to the resistor 302. The resistor 302 connected to the cathode 301-2 of the diode 301 may be connected to the signal path 320. For example, the cathode 303-2 of the diode 303 may be connected to the resistor 304. The resistor 304 connected to the cathode 303-2 of the diode 303 may be connected to the signal path 330. According to an embodiment, the signals passing through the diodes 301 and 303 may be added to the clock signal and/or the data signal transmitted from the controller 210 to interfere with the operation of the RFIC 220. The RFIC 220, the amplifier 235, and/or the power supply 240, based on the control signals transmitted from the controller 210 and/or the signals passed through the diodes 301 and 303, may perform an operation different from the control of the controller 210. For example, the signals passing through the diodes 301 and 303 may cause distortion of the control signals, thereby temporarily interrupting the control of the RFIC 220, the amplifier 235, and/or the power supply 240.

As described above, the electronic device 101 can control, based on the signals obtained by the diodes 301 and 303, the controller 210, the RFIC 220, and/or the power supply 240, thereby preventing damage (or burn-out) to the amplifier 235. Further, as described above, the electronic device 101 can regulate the amplitude of the radio signal to be radiated from the RFIC 220 to the outside, based on the signals passing through the diodes 301 and 303, thereby preventing damage (or burn-out) to the amplifier 235.

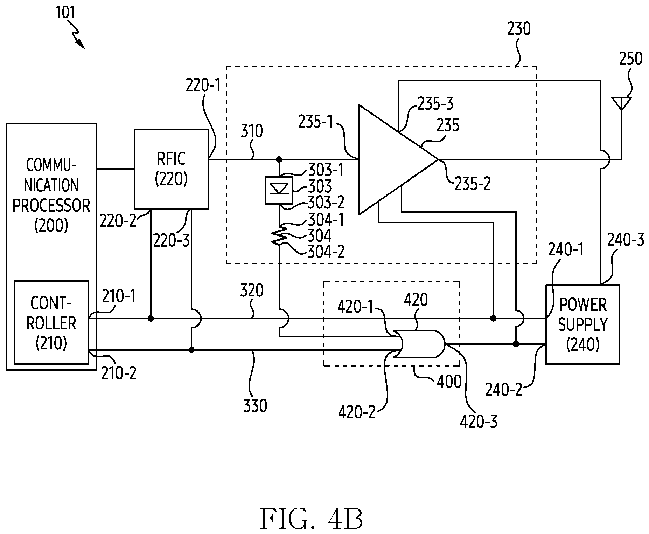

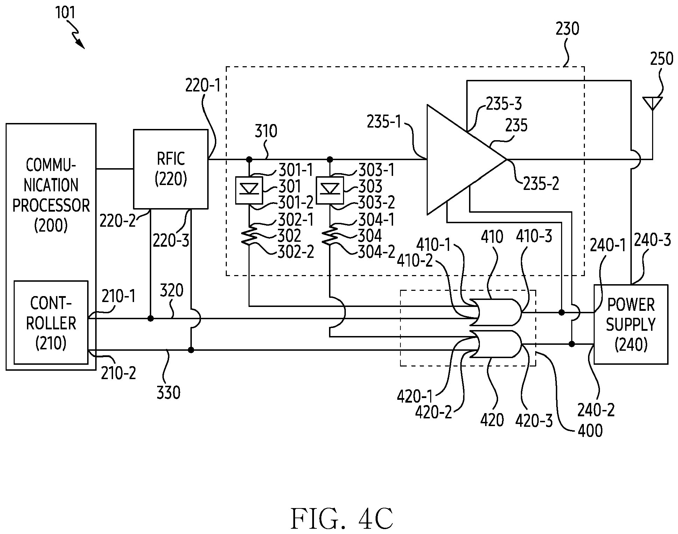

FIGS. 4A to 4C each illustrate an example of a circuit diagram of a portion of an RFFE included in an electronic device according to an embodiment. The electronic device 101 of FIGS. 4A to 4C may correspond to the electronic device 101 of FIGS. 1 to 3C. The RFFE 230 of FIGS. 4A to 4C may correspond to the RFFE 230 of FIGS. 2A to 3C. The controller 210 of FIGS. 4A to 4C may correspond to the controller 210 of FIGS. 2A to 3C. The RFIC 220 of FIGS. 4A to 4C may correspond to the RFIC 220 of FIGS. 2A to 3C. The power supply 240 of FIGS. 4A to 4C may correspond to the power supply 240 of FIGS. 2A to 3C. The antenna 250 of FIGS. 4A to 4C may correspond to the antenna 250 of FIGS. 2A to 3C. The diode 301 of FIGS. 4A and/or 4C may correspond to the diode 237 of FIGS. 2A and 2B and/or the diode 301 of FIGS. 3A and/or 3C. And the diode 303 of FIGS. 4B and 4C may correspond to the diode 237 of FIGS. 2A to 2B and/or the diode 303 of FIGS. 3B and 3C.

Referring to FIGS. 4A to 4C, the electronic device 101 may include a communication processor 200, a controller 210, an RFIC 220, an RFFE 230, a logic circuit 400, a power supply 240, and an antenna 250, wherein the RFFE 230 may include an amplifier 235, a diode 301, and/or a diode 303.

Referring to FIG. 4A, according to an embodiment, the RFFE 230 may further include a logic circuit 400. For example, a logic gate 410 may correspond to the logic circuit 400. The logic gate 410 may be connected to prevent transmission of the signal obtained through the diode 301 to the signal path 320 between the controller 210 and the gate 410.

According to an embodiment, the anode 301-1 of the diode 301 may be connected to the signal path between the RFIC 220 and the amplifier 235. The cathode 301-2 of the diode 301 may be connected to the input terminal 410-1 of the gate 410. The controller 210 may be connected to the input terminal 410-2 of the gate 410. The logic gate 410 may be electrically connected to the signal path 320 through which the clock signal is transmitted from controller 210. An output terminal 410-3 of the gate 410 may be connected to the power supply 240. For example, the gate 410 may include an OR gate. According to an embodiment, the gate 410 may output the signal indicating the digital value of 1 at the output terminal 410-3, based on receiving a signal indicating a digital value of 1 at the input terminal 410-1 and/or the input terminal 410-2.

According to an embodiment, the controller 210 may transmit the clock signal and/or the data signal to the RFIC 220, the amplifier 235, and/or the power supply 240. The controller 210 may control the amplifier 235, based on transmitting the clock signal and/or the data signal to the controller of the amplifier 235.

According to an embodiment, the power supply 240 may apply a voltage to the amplifier 235, based on the signal indicating the digital value of 1 output from the gate 410 and the signal transmitted from the controller 210 through the signal path 330. The amplifier 235 may amplify the signal of radio frequency band transmitted from the RFIC 220, based on the voltage being applied as a designated voltage, and transmit the amplified signal to the antenna 250.

According to an embodiment, the cathode 301-2 of the diode 301 may be connected to the resistor 302. For example, the resistor 302 may include one end 302-1 connected to the cathode 301-2 of the diode 301 and the other end 302-2 connected to the input terminal 410-1 of the gate 410. The resistor 302 may be connected to prevent damage to the diode 301 by regulating the voltage applied to the diode 301.

The following Table 1 is to enumerate examples of various operations of the communication processor 200, the controller 210, and the RFIC 220.

**[Table 2]**

| **Cases** | **Amplitude of Radio Signal designated in Communicati on Processor** | **Signal Blockin g by Diode** | **Transmissio n of Clock Signal by Controller** | **Operatio n of Controll er** | **Amplitud e of Signal transmitt ed from RFIC** | **Contr ol of Powe r Suppl Y** |
|---|---|---|---|---|---|---|
| **7^{th} Case** | 0dBm | o | o | o | 0dBm | o |
| **8^{th} Case** | 5dBm | o | o | o | 5dBm | o |
| **9^{th} Case** | 6dBm | o | o | o | 6dBm | o |
| **10^{th} Case** | 7dBm | x | x | x | 7dBm | x |
| **11^{th} Case** | 8dBm | x | x | x | 8dBm | x |
| **12^{th} Cas e** | 6dBm | o | o | o | 6dBm | o |

Referring to Table 2, the seventh to ninth cases may refer to a normal operating state of the controller 210, the RFIC 220, and/or the power supply 240. The seventh to ninth cases may be in substantially the same state as the first to third cases of the above Table 1. The 10^{th} to 11^{th} cases may be of a state that the signal obtained through the diode 301 is transmitted to the gate 410. For example, in the tenth to eleventh cases, the power supply 240 may apply the voltage of the previous case (e.g., 9^{th} case) to the power input 235-3 of the amplifier 235, based on the signal transmitted from the gate 410. For example, the controller 210 may transmit the clock signal to the RFIC 220, the amplifier 235, and/or the gate 410. For example, the clock signal transmitted from the controller 210 may include a repetition of a signal indicating a digital value of 0 and a signal indicating a digital value of 1. The RFIC 220 may transmit a radio signal having a designated magnitude, based on the signal transmitted from the controller 210 and/or the communication processor 200. The amplifier 235 may amplify the signal transmitted from the RFIC 220 to transmit the radio signal to the antenna 250 via the output terminal 235-3.

The 12^{th} case may be of a state that, subsequent to the eleventh case, the communication processor 200, the controller 210, the RFIC 220, and/or the power supply 240 are normally operating.

Referring to FIG. 4B, according to an embodiment, the RFFE 230 may further include a logic gate 420. For example, the gate 420 may include an OR gate. According to an embodiment, the diode 303 may include an anode 303-1 connected to the signal path 310 and a cathode 303-2 connected to an input terminal 420-1 of the gate 420. The gate 420 may be connected to the signal path 330 through which data signals are transmitted from the controller 210.

According to an embodiment, the gate 420 may transmit, based on receiving the signal indicating the digital value of 1 at the input terminal 420-1 and/or the input terminal 420-2, the signal indicating the digital value of 1 through the output terminal 420-3 of the gate 420. The power supply 240 may apply a voltage through the power input terminal of the amplifier 235, based on the clock signal transmitted from the controller 210 and the data signal transmitted from the output terminal 420-3.

According to an embodiment, the RFIC 220 may transmit a signal in a radio frequency band to the amplifier 235. The diode 303 may transmit the signal in the radio frequency band to the gate 420, based on a designated voltage and/or a designated power or higher. The signal may include the signal indicating the digital value of 1.

Referring to FIG. 4C, an electronic device 101 according to an embodiment may include a logic gate 410 and a logic gate 420 included in the logic circuit 400. For example, the gate 410 may be connected to the diode 301 and the output terminal 210-1 of the controller 210. One input terminal 410-1 of the gate 410 may be connected to the cathode 301-2 of the diode 301. The other input terminal 410-2 of the gate 410 may be connected to the output terminal 210-1 transmitting the clock signal of the controller 210. An output terminal 410-3 of the gate 410 may be connected to the power supply 240.

According to an embodiment, the anode 301-1 of the diode 301 may be connected to the signal path 310 between the RFIC 220 and the amplifier 235. The anode 303-1 of diode 303 may be also connected to the signal path 310 between the RFIC 220 and the amplifier 235. For example, the diode 301 and/or the diode 303 may transmit the signal transmitted from RFIC 220 to the gate 410 and/or the gate 420.

According to an embodiment, the diode 301 may be connected to a resistor 302. For example, the cathode 301-2 of the diode 301 may be connected to the resistor 302. The resistor 302 includes one end 302-1 connected to the cathode 301-2 of the diode 301 and the other end 302-2 connected to the input terminal 410-1 of the gate 410.

According to an embodiment, the diode 303 may be connected to the resistor 304. For example, the cathode 303-2 of the diode 303 may be connected to the resistor 304. The resistor 304 includes one end 304-1 connected to the cathode 303-2 of the diode 303 and the other end 304-2 connected to the input terminal 420-1 of the gate 420. For example, the resistor 302 coupled to the diode 301 and the resistor 304 coupled to the diode 303 may be arranged to prevent damage to the diodes 301 and 303, respectively. For example, the resistors 302 and 304 can prevent damage to the diodes 301 and 303, by means of dispersing the voltage applied to the diodes 301 and 303.

For example, the gate 420 may be connected to the diode 303 and the output terminal 210-2 of the controller 210. One input terminal 420-1 of the gate 420 may be connected to the cathode 303-2 of the diode 303. The other input terminal 420-2 of the gate 420 may be connected to the output terminal 210-2 transmitting the data signal of the controller 210. An output terminal 420-3 of the gate 420 may be connected to the power supply 240.

For example, the power supply 240 may be connected to the power input terminal 235-3 of the amplifier 235. The power supply 240 may apply a voltage to the amplifier 235, based on the signals transmitted from the gate 410 and the gate 420.

According to an embodiment, the RFIC 220 may transmit the radio frequency band signal to the antenna 250. For example, the RFIC 220 may regulate the signal level, based on the clock signal transmitted from the controller 210 and the data signal transmitted from the controller 210.

As described above, the electronic device 101 includes the gate 410 and/or the gate 420, thereby regulating the amplitude of the radio signal transmitted from the RFIC 220 for radiation to the outside, independently of controlling of the power supply 240 so as to prevent damage (or burn-out) to the amplifier 235.

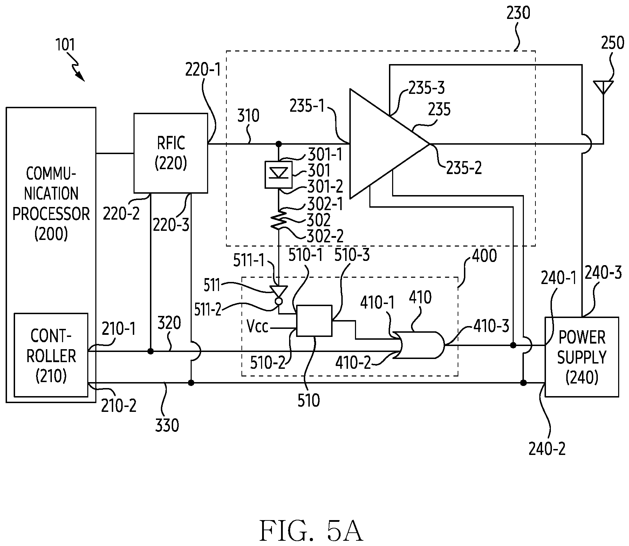

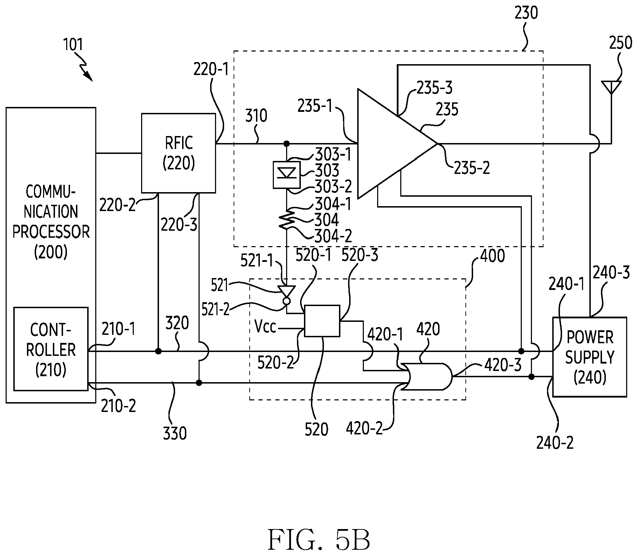

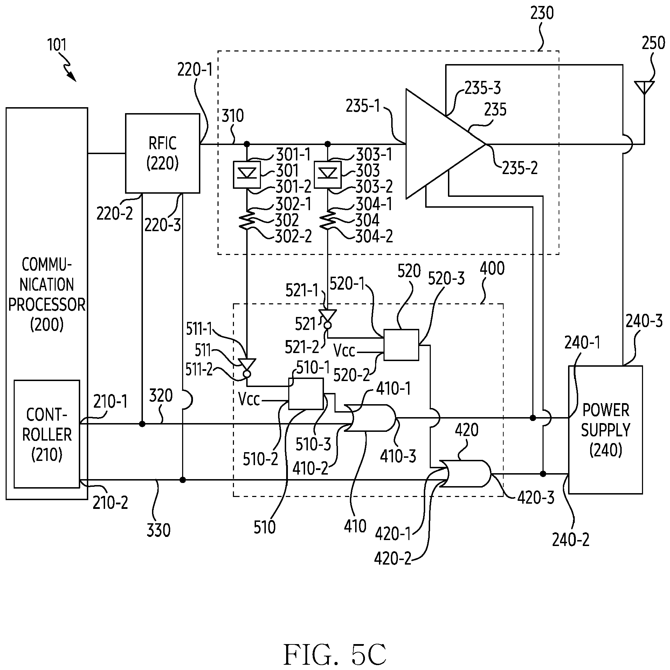

FIGS. 5A to 5C each illustrate an example of a circuit diagram of a portion of an RFFE in an electronic device according to an embodiment. The electronic device 101 of FIGS. 5A to 5C may correspond to the electronic device 101 of FIGS. 1 to 4C. The RFFE 230 of FIGS. 5A to 5C may correspond to the RFFE 230 of FIGS. 2A to 4C. The controller 210 of FIGS. 5A to 5C may correspond to the controller 210 of FIGS. 2A to 4C. The RFIC 220 of FIGS. 5A to 5C may correspond to the RFIC 220 of FIGS. 2A to 4C. The power supply 240 of FIGS. 5A to 5C may correspond to the power supply 240 of FIGS. 2A to 5C. The antenna 250 of FIGS. 5A to 5C may correspond to the antenna 250 of FIGS. 2A to 5C. The diode 301 of FIGS. 5A and/or 5C may correspond to the diode 237 of FIGS. 2A to 2B or the diode 301 of FIGS. 3A, 3C, 4A, and/or 4C. The diode 303 of FIGS. 5B and/or 5C may correspond to the diode 237 of FIGS. 2A to 2B, or the diode 303 of FIGS. 3B to 3C, and/or FIGS. 4B to 4C. The logic circuit 400 of FIGS. 5A to 5C may correspond to the logic circuit 400 of FIGS. 4A to 4C. The gate 410 of FIGS. 5A and/or 5C may correspond to the gate 410 of FIGS. 4A and/or 4C. The gate 420 of FIGS. 5B to 5C may correspond to the gate 420 of FIGS. 4B to 4C.

Referring to FIGS. 5A to 5C, the electronic device 101 may include a controller 210, an RFIC 220, an RFFE 230, an amplifier 235, a diode 301, a diode 303, a logic circuit 400, a power supply 240, and/or an antenna 250. The logic circuit 400 may include a bistable circuit 510 and/or a bistable circuit 520. For example, the bistable circuit 510 and/or the bistable circuit 520 may include latches and/or flip-flops.

Referring to FIG. 5A, according to an embodiment, the diode 301 includes an anode 301-1 connected to the signal path 310 between the RFIC 220 and the amplifier 235, and a cathode 301-2 connected to an input terminal 511-1 of an inverter 511. For example, the diode 301 may transmit the signal to the inverter 511, based on the amplitude of the signal transmitted from the RFIC 220 being greater than or equal to a designated voltage.

According to an embodiment, the logic circuit 400 may include a gate 410, a bistable circuit 510, and/or an inverter 511. For example, an input terminal 410-1 of the gate 410 may be connected to an output terminal 510-3 of the bistable circuit 510. An input terminal 410-2 of the gate 410 may be connected to an output terminal 210-1 for receiving the clock signal of the controller 210. An output terminal 410-3 of the gate 410 may be connected to the power supply 240.

According to an embodiment, the bistable circuit 510 may include an SR latch and/or an SR flip-flop. An input terminal 510-1 of the bistable circuit 510 may be connected to the output terminal 511-2 of the inverter 511. A voltage may be applied to another input terminal 510-2 of the bistable circuit 510. For example, the inverter 511 may be connected to the diode 301. The input terminal 511-1 of the inverter 511 may be connected to the cathode 301-2 of the diode 301. The output terminal 510-3 of the bistable circuit 510 may be connected to an input terminal 410-1 of the gate 410. The gate 410 has one input terminal 410-1 for receiving a signal transmitted from the bistable circuit 510, another input terminal 410-2 for receiving a clock signal transmitted from the controller 210, and an output terminal 410-3 for transmitting a signal for controlling the power supply 240. The power supply 240 may be connected to the power input terminal 235-3 of the amplifier 235 to control an active state of the amplifier 235. The power supply 240 may regulate the voltage applied to the amplifier 235, based on receiving the signal transmitted from the output terminal 410-3 of the gate 410 and the data signal transmitted from the controller 210.

According to an embodiment, the cathode 301-2 of the diode 301 may be connected to the resistor 302. The input terminal 511-1 of the inverter 511 may be connected to the resistor 302. For example, the resistor 302 may include one terminal 302-1 connected to the cathode 301-2 of the diode 301 and the other terminal 302-2 connected to the input terminal 511-1 of the inverter 511.

For example, the signal output from the output terminal 510-3 of the bistable circuit 510 may be as shown in Table 3 below.

**[Table 3]**

| **Cases** | **Signal Input to Input Terminal 510-1** | **Signal Input to Input Terminal 510-2** | **Signal Output from Output Terminal 501-3** |
|---|---|---|---|
| **13^{th} Case** | 0 | 0 | No change |
| **14^{th} Case** | 1 | 0 | 1 |
| **15^{th} Case** | 0 | 1 | 0 |
| **16^{th} Case** | 1 | 1 | - |

Referring to the Table 3, in the 13^{th} case, the bistable circuit 510 may output the signal prior to receiving the signal indicating the digital value of 0, based on receiving the signal indicating the digital value of 0 via the input terminal 510-1 and the input terminal 510-2. For example, the bistable circuit 510 may output, when the signal output from the output terminal 501-3 is Q(t+1), Q(t) based on receiving the signal indicating the digital value of 0 through the input terminal 510-1 and the input terminal 510-2. In the 14^{th} case, the bistable circuit 510 may receive the signal indicating the digital value of 1 through the input terminal 510-1. The bistable circuit 510 may receive the signal indicating the digital value of 0 through the input terminal 510-2. The bistable circuit 510 may output the signal indicating the digital value of 1 through the output terminal 510 -3, based on the signal indicating the digital value of 1 input to the input terminal 510-1 and the signal indicating the digital value of 0 input to the input terminal 510-2.

In the 15^{th} case, the bistable circuit 510 may receive the signal indicating the digital value of 0 through the input terminal 510-1. The bistable circuit 510 may receive the signal indicating the digital value of 1 through the input terminal 510-2. The bistable circuit 510 may output the signal indicating a digital value of 0 through the output terminal 510-3, based on receiving the signal indicating the digital value of 0 through the input terminal 510-1 and the signal indicating the digital value of 1 through the input terminal 510-2. For example, in the fifteenth case, the bistable circuit 510 may output the signal indicating the digital value of 0 via the output terminal 510-3 to reset the controller 210.

In the 16^{th} case, the bistable circuit 510 may receive the signal indicating the digital value of 1 through the input terminal 510-1. The bistable circuit 510 may receive the signal indicating the digital value of 1 through an input terminal 510-2. For example, when the bistable circuit 510 receives the signal indicating the digital value of 1 through the input terminal 510-1 and the signal indicating the digital value of 1 through the input terminal 510-2, it may not perform a normal operation. For example, when the digital value of 1 is input to the input terminal 510-1 and the input terminal 510-2 of the bistable circuit 510, respectively, it may not be defined.

The following Table 4 is to enumerate examples of various operations of the communication processor 200, the controller 210, and the RFIC 220.

**[Table 4]**

| **Cases** | **Amplitude of Radio Signal designated in Communicati on Processor** | **Signal Blocki ng by Diode** | **Transmissi on of Clock Signal by Controller** | **Operatio n of Controlle r** | **Amplitud e of Signal transmitt ed from RFIC** | **Contro l of Power Supply** |
|---|---|---|---|---|---|---|
| **17^{th} Case** | 0dBm | o | o | o | 0dBm | o |
| **18^{th} Case** | 5dBm | o | o | o | 5dBm | o |
| **19^{th} Case** | 6dBm | o | o | o | 6dBm | o |
| **20^{th} Case** | 7dBm | x | x | x | 7dBm | x |
| **21^{st} Case** | 8dBm | x | x | x | 8dBm | x |
| **22^{nd} Case** | 6dBm | o | o | o | 6dBm | o |

In the 17^{th} to 19^{th} cases, the controller 210 may transmit the clock signal and the data signal to the RFIC 220 and/or the power supply 240 to control the RFIC 220 and/or the power supply 240. For example, the RFIC 220 may transmit a signal having a magnitude designated by the communication processor 200 to the amplifier 235, based on the signal transmitted from the controller 210. For example, the power supply 240 may apply a designated voltage to the power input terminal 235-3 of the amplifier 235, based on the signal transmitted from the controller 210. For example, the amplifier 235 may receive the signal transmitted from the RFIC 220 through the input terminal 235-1, and amplify the signal and transmit it via the output terminal 235-2, based on application of the designated voltage to the power input terminal 235-3. In the 20^{th} case, the diode 301 may, based on the signal transmitted from the RFIC 220 having the designated power (e.g., 7 dBm) or higher, transmit the signal to the inverter 511. The signal obtained via the diode 301 may be input to the bistable circuit 510 through the inverter 511. The bistable circuit 510 may output from the output terminal 510-3 of the bistable circuit 510, based on signals input to the bistable circuit 510. The signal output through the output terminal 510-3 and the clock signal transmitted from the controller 210 may be input to the gate 410. The gate 410 may, based on the signal output through the output terminal 510-3 and the clock signal transmitted from the controller 210, transmit the signal output through the output terminal 410-3 to the power supply 240. The signal output through the output terminal 410-3 may be transmitted to the power supply 240 to regulate the amplitude of the voltage applied from the power supply 240 to the amplifier 235. The amplifier 235 may maintain the level of the signal transmitted from the RFIC 220, based on the application of the regulated voltage and transmit the same to the antenna 250. The 21^{st} case may be substantially the same as the 20^{th} case.

In the 22^{nd} case, the diode 301 may block transmission of the signal transmitted from the RFIC 220 having less than the designated power to the inverter 511. The bistable circuit 510 may transmit the signal indicating the digital value of 1 to the gate 410 while the signal is blocked by the diode 301. The gate 410 may transmit a signal to control the power supply 240 to the power supply 240, based on the signal transmitted from bistable circuit 510. While the signal is blocked by the diode 301, the controller 210 may transmit the clock signal to the RFIC 220 and transmit the signal for the normal operation of the RFIC 220. For example, the communication processor 200 may transmit the signal for transmitting a signal having a magnitude of about 6 dBm by the RFIC 220. The RFIC 220 may transmit a radio signal having a magnitude of about 6 dBm to the amplifier 235, based on the signal transmitted from the communication processor 200. The amplifier 235 may transmit the radio signal of about 6 dBm to the antenna 250, while maintaining the level of the radio signal of about 6 dBm.

Referring to FIG. 5B, according to an embodiment, the diode 303 may include an anode 303-1 connected to the signal path between the RFIC 220 and the amplifier 235, and a cathode 303-2 connected to the input terminal 521-1 of the inverter 521.

According to an embodiment, the logic circuit 400 may further include a gate 420, a bistable circuit 520, and/or an inverter 521. For example, the bistable circuit 520 may include an SR latch and/or an SR flip-flop. For example, an input terminal 420-1 of the gate 420 may be connected to the output terminal 520-3 of the bistable circuit 520. Another input terminal 420-2 of the gate 420 may be connected to an output terminal 210-2 for transmitting a data signal transmitted from the controller 210. The output terminal 420-3 of the gate 420 may be connected to the power supply 240.

According to an embodiment, the input terminal 520-1 of the bistable circuit 520 may be connected to the output terminal 521-2 of the inverter 521. A voltage may be applied to the input terminal 520-2 of the bistable circuit 520. For example, the inverter 521 may be coupled to the diode 303. The input terminal 521-1 of the inverter 521 may be connected to the cathode 303-2 of the diode 303. The output terminal 520-3 of the bistable circuit 520 may be connected to the input terminal 420-1 of the gate 420. For example, the bistable circuit 520 may perform substantially the same operation as the bistable circuit 510, but the disclosure is not limited thereto.

According to an embodiment, the power supply 240 may be connected to the power input terminal 235-3 of the amplifier 235 to apply a voltage for regulating the level of the signal input to the amplifier 235. The power supply 240 may regulate the voltage applied to the amplifier 235, based on the signal transmitted from the output terminal 420-3 of the gate 420 and the clock signal transmitted from the controller 210. For example, the voltage applied to the amplifier 235 by the power supply 240 may be regulated based on the signal transmitted from output terminal 420-3 of gate 420 and the clock signal transmitted from the controller 210.

According to an embodiment, the diode 303 may be connected to the resistor 304. For example, the cathode 303-2 of the diode 303 may be connected to the resistor 304. The resistor 304 may include one end 304-1 connected to the cathode 303-2 of the diode 303 and the other end 304-2 connected to the input terminal 521-1 of the inverter 521.

Referring to FIG. 5C, the RFFE 230 may include an amplifier 235, a diode 301, and/or a diode 303. The electronic device 101 may include a gate 410, a gate 420, a bistable circuit 510, an inverter 511, a bistable circuit 520, and/or an inverter 521.

According to an embodiment, the cathode 301-2 of the diode 301 may be connected to the input terminal 511-1 of the inverter 511. The output terminal 511-2 of the inverter 511 may be connected to the input terminal 510-1 of the bistable circuit 510. A voltage may be applied to the input terminal 510-2 of the bistable circuit 510. The output terminal 510-3 of the bistable circuit 510 may be connected to the input terminal 410-1 of the gate 410. An input terminal 410-2 of the gate 410 may receive the clock signal of the controller 210. An output terminal 410-3 of the gate 410 may be connected to the power supply 240. The cathode 303-2 of the diode 303 may be connected to the input terminal 521-1 of the inverter 521. The output terminal 521-2 of the inverter 521 may be connected to the input terminal 520-1 of the bistable circuit 520. A voltage may be applied to the input terminal 520-2 of the bistable circuit 520. The output terminal 520-3 of the bistable circuit 520 may be connected to the input terminal 420-1 of the gate 420. The input terminal 420-2 of the gate 420 may receive the data signal transmitted from the controller 210. The output terminal 420-3 of the gate 420 may be connected to the power supply 240. The power supply 240 may be connected to the power input terminal 235-3 of the amplifier 235.

According to an embodiment, the RFFE 230 may further include resistors 302 and 304. For example, the cathode 301-2 of the diode 301 may be connected to the resistor 302. An input terminal 511-1 of the inverter 511 may be connected to the resistor 302. The resistor 302 may include one end 302-1 connected to the cathode 301-2 of the diode 301 and the other end 302-2 connected to the input terminal 511-1 of the inverter 511. For example, the cathode 303-2 of the diode 303 may be connected to the resistor 304. An input terminal 521-1 of the inverter 521 may be connected to the resistor 304. The resistor 304 may include one terminal 304-1 connected to the cathode 303-2 of the diode 303 and the other terminal 304-2 connected to the input terminal 521-1 of the inverter 521.

For example, the power supply 240 may apply a voltage to amplify the amplitude of the signal transmitted from RFIC 220 to the amplifier 235, based on the signal transmitted from the gate 410 and/or the signal transmitted from the gate 420. While transmitting the signal in radio frequency band to the antenna 250, the RFIC 220 may regulate the amplitude of the radio signal in the radio frequency band, based on the signal transmitted from the controller 210.

According to an embodiment, the controller 210 may control the RFIC 220 while the power supply 240 is controlled based on signals passing through the diodes 301 and 303. For example, the clock signal and the data signal transmitted from the controller 210 may control the RFIC 220. The clock signal and the data signal transmitted from the controller 210 may be input to the gates 410 and 420. The signals input to the gates 410 and 420 and the signals obtained through the diodes 301 and 303 may cause a change in voltage applied from the power supply 240 to the amplifier 235. While the power supply 240 receives the signals input to the gates 410 and 420 and the signals obtained via the diodes 301 and 303, the control by the controller 210 may be ceased. While the control by the controller 210 is suspended, the power supply 240 may apply a voltage to the amplifier 235, the voltage being a voltage before receiving the signal to cease the control of the controller 210.

For example, in a state in which the signals input to the gates 410 and 420 through the diodes 301 and 303 are transmitted to the power supply 240, the power supply 240 may be unable to identify the timing points of sampling the data signal from the clock signal. In such a state, sampling of the data signal is ceased, so that the control by the controller 210 of the power supply 240 may be temporarily interrupted.

As described above, while transmitting the radio signal in a radio frequency band from the RFIC 220, the electronic device 101 may control the operation of the amplifier 235 using the signal obtained based on the diodes 301 and 303, thereby preventing damage (or burn-out) of the amplifier 235. As described above, while the power supply 240 is controlled based on the signals obtained through the diodes 301 and 303, the electronic device 101 may control the RFIC 220 independently, thereby preventing the amplifier 235 from being damaged (or burnt out).

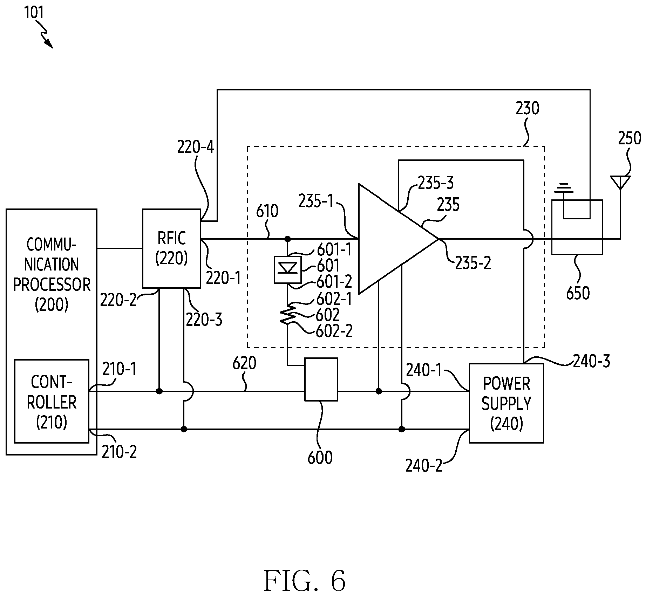

FIG. 6 illustrates an example of a circuit diagram of a portion of an RFFE included in an electronic device according to an embodiment. The electronic device 101 of FIG. 6 may correspond to the electronic device 101 of FIGS. 1 to 5C. The communication processor 200 of FIG. 6 may correspond to the communication processor 200 of FIGS. 2A to 5C. The RFFE 230 of FIG. 6 may correspond to the RFFE 230 of FIGS. 2A to 5C. The controller 210 of FIG. 6 may correspond to the controller 210 of FIGS. 2A to 5C. The RFIC 220 of FIG. 6 may correspond to the RFIC 220 of FIGS. 2A to 5C. The power supply 240 of FIG. 6 may correspond to the power supply 240 of FIGS. 2A to 5C. The antenna 250 of FIG. 6 may correspond to the antenna 250 of FIGS. 2A to 5C. The diode 601 of FIG. 6 may correspond to the diode 237 in FIG. 2A, the diode 301 in FIGS. 3A, 3C, 4A, 4C, 5A, and/or 5C, or the diode 303 in FIGS. 3B, 3C, 4B, 4C and FIGS. 5A to 5C.

Referring to FIG. 6, according to an embodiment, the RFFE 230 may further include a diode 601 and/or a coupler 650. According to an embodiment, the RFIC 220 may include a detector (e.g., an RF power detector) for detecting a signal transmitted from the amplifier 235 to the antenna 250. According to an embodiment, the RFIC 220 may receive a signal obtained from the coupler 650 through a detection terminal 220-4. The signal received through the detection terminal 220-4 may be identified by means of a detector (not shown) included in the RFIC 220.

According to an embodiment, the communication processor 200 may include a controller 210. The communications processor 200 may be operatively coupled with the RFIC 220. The communication processor 200 may control the operation of the controller 210. The communication processor 200 may control the operation of the RFIC 220. According to an embodiment, the controller 210 may transmit the clock signal and/or the data signal through the signal path 620. The control signals (e.g., clock signals, and/or data signals) transmitted via the signal path 620 may include signals to control the components in the RFIC 220, the amplifier 235, the power supply 240, and/or the RFFE 230.

According to an embodiment, the diode 601 may be connected between the signal path 610 and the signal path 620. For example, the diode 601 may include an anode 601-1 connected to the signal path 610 and a cathode 601-2 connected to the signal path 620. The diode 601 may transmit the signal from the signal path 610 to the signal path 620, based on the signal transmitted from RFIC 220 having the designated voltage (e.g., 0.7V) and/or designated power (e.g., 6dBm) or higher. For example, the signal may control the operation of the RFIC 220 and/or the power supply 240.

According to an embodiment, the diode 601 may be connected to the resistor 602. For example, the resistor 602 may include one end 602-1 connected to the cathode 601-2 of the diode 601 and the other end 602-2 connected to the signal path 620. The resistor 602 may prevent damage to the diode 601 by regulating the voltage applied to the diode 601.

According to an embodiment, the coupler 650 may be disposed in the signal path between the amplifier 235 and the antenna 250 to obtain a signal transmitted from the amplifier 235 to the antenna 250, and transmit the signal to the detector included in the RFIC 220. The magnitude of the signal obtained by the coupler 650 may be relatively small compared to that of the signal transmitted from the amplifier 235.

According to an embodiment, the RFIC 220 may transmit a signal to the communication processor 200, based on the signal obtained by the coupler 650. For example, the signal obtained by the coupler 650 may maintain a certain constant level for a designated time period. When the signal obtained by the coupler 650 maintains the constant level for the designated time period, the RFIC 220 may transmit a signal to initialize the controller 210 to the communication processor 200. The communication processor 200 may initialize the controller 210, based on receiving the signal to initialize the controller 210 transmitted from the RFIC 220. Based on the initialization, the controller 210 may transmit signals to the RFIC 220 and/or the power supply 240.

According to an embodiment, the communication processor 200 may identify an operation of the controller 210. For example, the communication processor 200 may cause the controller 210 to be reset when transmission of signals from the controller 210 is stopped for a designated period of time. According to an embodiment, the communication processor 200 may cause the controller 210 to be reset based on maintaining power of the signal transmitted from the RFIC 220 for a designated time period.

According to an embodiment, the logic circuit 600 may store a signal transmitted from a counter and/or the diode 601. The communication processor 200 may identify a signal transmitted from the diode 601 having less than a designated power. The communication processor 200 may cause the controller 210 to reset when the signal transmitted from the diode 601 having less than the designated power is identified at a designated number of times or more.

According to an embodiment, the RFIC 220 may regulate the amplitude of the signal transmitted to the amplifier 235, based on the signal obtained through the coupler 650. For example, the RFIC 220 may reduce the amplitude of the signal transmitted to the amplifier 235, based on identifying that the signal obtained through the coupler 650 has a designated power or higher.

As described above, the electronic device 101 can control the magnitude of the signal transmitted from the RFIC 220, based on the signal obtained through the coupler 650, thereby preventing damage (or burn-out) to the amplifier 235.

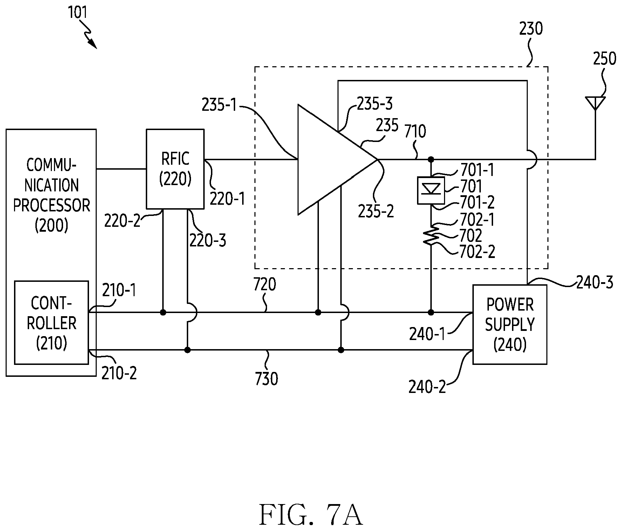

FIGS. 7A to 7C illustrates shows a circuit diagram of a portion of the RFFE included in the electronic device. The electronic device 101 of FIGS. 7A to 7C may correspond to the electronic device 101 of FIGS. 1 to 6. The communication processor 200 of FIGS. 7A to 7C may correspond to the communication processor 200 of FIGS. 2A to 6. The controller 210 of FIGS. 7A to 7C may correspond to the controller 210 of FIGS. 2A to 6. The RFIC 220 of FIGS. 7A to 7C may correspond to the RFIC 220 of FIGS. 2A to 6. The amplifier 235 of FIGS. 7A to 7C may correspond to the amplifier 235 of FIGS. 2A to 6. The power supply 240 of FIGS. 7A to 7C may correspond to the power supply 240 of FIGS. 2A to 6. The antenna 250 of FIGS. 7A to 7C may correspond to the antenna 250 of FIGS. 2A to 6.

Referring to FIGS. 7A to 7C, according to an embodiment, the electronic device 101 may include a communication processor 200, a controller 210, an RFIC 220, an RFFE 230, a power supply 240, and/or antenna 250. The RFFE 230 may further include an amplifier 235, a diode 701, and/or a diode 703. Although FIGS. 7A to 7C each illustrate that the diodes 701 or diode 703 is shown in singular, they may be in plural.

According to an embodiment, the communication processor 200 may include a controller 210. The communication processor 200 may be operatively coupled to the RFIC 220. The communication processor 200 may control the controller 210 and/or the RFIC 220.

According to an embodiment, the controller 210 may transmit the control signals (e.g., the clock signal and/or the data signal) to the RFIC 220. The RFIC 220 may operate based on the control signals transmitted from the controller 210. According to an embodiment, the controller 210 may transmit the control signals to a controller included in the amplifier 235. The amplifier 235 may operate based on the control signals received by a controller included in the amplifier 235. For example, the amplifier 235 may amplify a radio frequency band of signal transmitted from the RFIC 220, based on the control signals received by the controller included in the amplifier 235, and transmit the amplified signal to the antenna 250. According to an embodiment, the controller 210 may transmit the control signals to the power supply 240. The power supply 240 may operate based on the control signals. For example, the power supply 240 may apply a voltage to amplify the signal transmitted from RFIC 220, to the amplifier 235, based on receiving the control signals.

Referring to FIG. 7A, the RFFE 230 may include an amplifier 235, a diode 701, and/or a resistor 702.

According to an embodiment, the RFIC 220 may include a sending end 220-1 connected to an input terminal 235-1 of the amplifier 235. The RFIC 220 may include a receiving end 220-2 to obtain a signal from the signal path 720. The RFIC 220 may include a receiving end 220-3 to obtain a signal from the signal path 730. The output terminal 235-2 of the amplifier 235 may be connected to the antenna 250.

According to an embodiment, the receiving end 240-1 of the power supply 240 may be connected to the signal path 720. The receiving end 240-2 of the power supply 240 may be connected to the signal path 730. For example, the receiving end 240-1 of the power supply 240 may be connected to a receiving end 220-2 of the RFIC 220, a sending end 210-1 of the controller 210, and/or a resistor 702. For example, the receiving end 240-2 of the power supply 240 may be connected to the receiving end 220-3 of the RFIC 220 and/or the sending end 210-2 of the controller 210.

According to an embodiment, the RFIC 220 may include a sending end 220-1. The sending end 220-1 may be connected to the input terminal 235-1 of the amplifier 235. The RFIC 220 may include a receiving end 220-2 to obtain a signal from the signal path 720 and/or a receiving end 220-3 to obtain a signal from the signal path 730. The output terminal 235-2 of the amplifier 235 may be connected to the antenna 250 and/or the anode 710-1 of the diode 701.

According to an embodiment, the number of diodes 701 is shown as singular, but it may be plural. The diode 701 may include an anode 701-1 and a cathode 701-2. For example, the anode 701-1 of the diode 701 may be connected to the signal path 710. The cathode 701-2 of the diode 701 may be connected to one terminal 702-1 of the resistor 702. For example, the diode 701 may, based on identifying the signal transmitted from amplifier 235 having the designated power (e.g., 35.1 dBm), and/or the designated voltage (e.g., 5.1 V) or higher, transmit the signal from the signal path 710 to the signal path 720. The clock signal transmitted from controller 210 may be added to the signal transmitted to the signal path 720 through diode 701. The signal added to the clock signal may be sent to the receiving end 220-2 of the RFIC 220 to interfere with the operation of the RFIC 220. The signal added to the clock may be sent to the receiving end 240-1 of the power supply 240 to interfere with the operation of the power supply 240.

The following Table 5 is to enumerate examples of various operations of the communication processor 200, the controller 210, and the RFIC 220.

**[Table 5]**

| **Cases** | **Amplitude of Radio Signal designated in Communicati on Processor** | **Signal Blocki ng by Diode** | **Transmissi on of Clock Signal by Controller** | **Operatio n of Controlle r** | **Amplitud e of Signal transmitt ed from RFIC** | **Contro l of Power Supply** |
|---|---|---|---|---|---|---|
| **23^{rd} Case** | 25dBm | o | o | o | 25dB m | o |
| **24^{th} Case** | 30Bm | o | o | o | 30dB m | o |
| **25^{th} Case** | 35dBm | o | o | o | 35dB m | o |
| **26^{th} Case** | 36dBm | x | x | x | 35dB m | x |
| **27^{th} Case** | 37dBm | x | x | X | 35dB m | x |
| **28^{th} Case** | 35dBm | o | o | o | 35dB m | o |

Referring to the Table 5, the 23rd to 25th cases and the 28th case may refer to a normal operating state of the communication processor 200, the controller 210, the RFIC 220, and/or the power supply 240. For example, in normal operating state (e.g., 23^{rd} to 25^{th} cases and 28^{th} case), the amplifier 235 may amplify the signal transmitted from the RFIC 220 and transmits it to the antenna 250. For example, in the normal operating condition, the power of the signal transmitted from amplifier 235 may include, for example, 25 dBm, 30 dBm, and/or 35 dBm. In the normal operating condition, the power supply 240 may apply a voltage to the power input terminal 235-3 of the amplifier 235 to amplify the signal sent to the amplifier 235. The 26^{th} to 27^{th} cases may refer to a state that causes the amplifier 235 to be damaged. In the 26^{th} to 27^{th} cases, the signal transmitted from the signal path 710 to the signal path 720 via the diode 701 may control the operation of the controller 210, the RFIC 220, the amplifier 235, and/or the power supply 240. For example, the 26^{th} to 27^{th} cases may refer to a case in which the signal having a designated power (e.g., 35.1 dBm) or more is transmitted through the signal path 710. The diode 701 may receive a signal having a designated power or higher from the signal path 710 and transmit it to the signal path 720. In a state the signal being transmitted through diode 701 to the signal path 720, the operation of the controller 210, the amplifier 235, and/or the power supply 240 may be disrupted. For example, the RFIC 220, the amplifier 235, and/or the power supply 240 may execute an operation different from the control instruction of the controller 210, based on the signal being received through the diode 701. The 28^{th} case may be of a state that the controller 210, the RFIC 220, the amplifier 235, and/or the power supply 240 operates in a normal state, subsequent to the 27^{th} case.

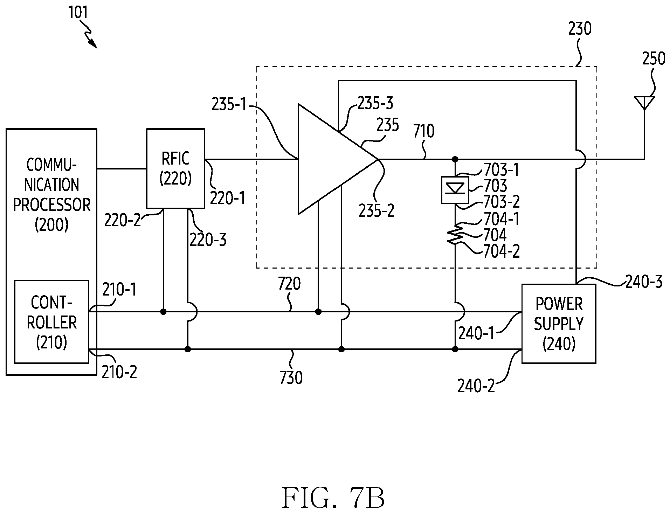

Referring to FIG. 7B, the RFFE 230 may include an amplifier 235, a diode 703, and/or a resistor 704.

According to an embodiment, the communication processor 200 may include a controller 210. Communications processor 200 may be operatively coupled to RFIC 220. An operation of the communication processor 200 may be substantially the same as that of the communication processor 200 of FIGS. 2A to 7A.

According to an embodiment, the sending end 210-1 of the controller 210 may be connected to the receiving end 220-2 of the RFIC 220 and/or the receiving end 240-1 of the power supply 240. The sending end 210-2 of the controller 210 may be connected to the receiving end 220-3 of the RFIC 220 and/or the receiving end 240-2 of the power supply 240.

According to an embodiment, the sending end 220-1 of the RFIC 220 may be connected to the input terminal 235-1 of the amplifier 235. The receiving end 220-2 of the RFIC 220 may be connected to the sending end 210-1 of the controller 210 and/or the receiving end 240-1 of the power supply 240. The receiving end 220-3 of the RFIC 220 may be connected to the sending end 210-2 of the controller 210 and/or the receiving end 240-2 of the power supply 240.

According to an embodiment, the input terminal 235-1 of the amplifier 235 may be connected to the sending end 220-1 of the RFIC 220. The output terminal 235-2 of the amplifier 235 may be connected to an anode 703-1 of the diode 703 and/or to the antenna 250. The power input terminal 235-3 of the amplifier 235 may be connected to the output terminal 240-3 of the power supply 240.

According to an embodiment, the receiving end 240-1 of the power supply 240 may be connected to the sending end 210-1 of the controller 210, and/or the receiving end 220-2 of the RFIC 220. The receiving end 240-2 of the power supply 240 may be connected to the receiving end 210-2 of the controller 210, the receiving end 220-3 of the RFIC 220, and/or the resistor 704.

According to an embodiment, the anode 703-1 of the diode 703 may be connected to the output terminal 235-2 of the amplifier 235 and/or the antenna 250. The cathode 703-2 of the diode 703 may be connected to one terminal 704-1 of the resistor 704. The diode 703 are shown in singular, but it may be in plural. The diode 703 may transmit the signal of a designated power and/or a designated voltage from the signal path 710 to the signal path 730, based on the signal transmitted from the amplifier 235 having a designated power (e.g., 35.1dbm) and/or a designated voltage (e.g., 5.1V) or higher.

According to an embodiment, the resistor 704 may be connected to the diode 703, the controller 210, and/or the power supply 240. One end 704-1 of the resistor 704 may be connected to the cathode 703-2 of the diode 703. The other end 704-2 of the resistor 704 may be connected to the power supply 240 and/or the controller 210.

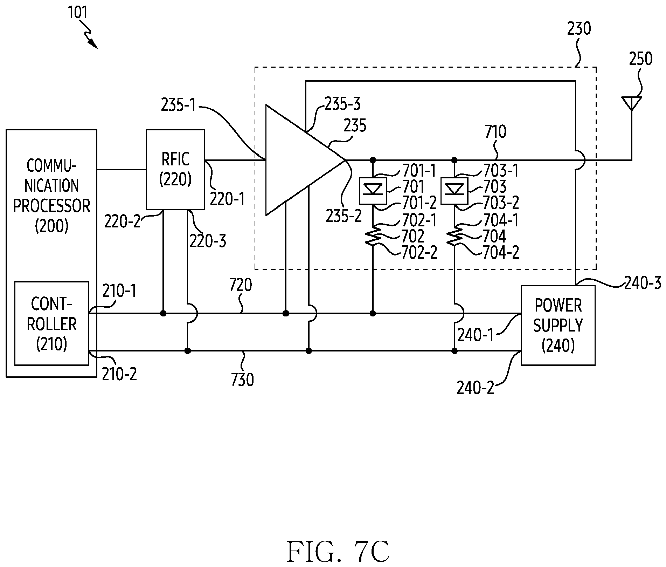

Referring to FIG. 7C, the RFFE 230 may include an amplifier 235, a diode 701, a resistor 702, a diode 703, and/or a resistor 704.

According to an embodiment, the controller 210 may be connected to the RFIC 220, the amplifier 235, the power supply 240, the resistor 702, and/or the resistor 704. The sending end 210-1 of the controller 210 may be connected to the receiving end 220-2 of the RFIC 220, the receiving end 240-1 of the power supply 240, and/or the resistor 702. The sending end 210-2 of the controller 210 may be connected to the receiving end 220-3 of the RFIC 220, the receiving end 240-2 of the power supply 240, and/or the resistor 704.

According to an embodiment, the amplifier 235 may be connected to the RFIC 220, the power supply 240, the diode 701, the diode 703, and/or the antenna 250. The input terminal 235-1 of the amplifier 235 may be connected to the sending end 220-1 of the RFIC 220. The output terminal 235-2 of the amplifier 235 may be connected to the anode 701-1 of the diode 701, the anode 703-1 of the diode 703, and/or the antenna 250. The power input terminal 235-3 of the amplifier 235 may be connected to the output terminal 240-3 of the power supply 240.

According to an embodiment, the diode 701 may be connected to the amplifier 235, the antenna 250, and/or the resistor 702. The anode 701-1 of the diode 701 may be connected to the output terminal 235-2 of the amplifier 235 and/or to the antenna 250. The cathode 701-2 of the diode 701 may be connected to one end 702-1 of the resistor 702.

According to an embodiment, the resistor 702 may be connected to the diode 701, the controller 210, the RFIC 220, and/or the power supply 240. One end 702-1 of the resistor 702 may be connected to the cathode 701-2 of the diode 701. The other end 702-2 of the resistor 702 may be connected to the receiving end 240-1 of the power supply 240, the receiving end 220-2 of the RFIC 220, and/or the sending end 210-1 of the controller 210.

According to an embodiment, the diode 703 may be connected to the amplifier 235, the antenna 250, and/or the resistor 704. An anode 703-1 of the diode 703 may be connected to an output terminal 235-2 of the amplifier 235 and/or the antenna 250. A cathode 703-2 of the diode 703 may be connected to one end 704-1 of the resistor 704.

According to an embodiment, the resistor 704 may be connected to the diode 703, the controller 210, the RFIC 220, and/or the power supply 240. One end 704-1 of the resistor 704 may be connected to the cathode 703-2 of the diode 703. The other end 704-2 of the resistor 704 may be connected to the receiving end 240-2 of the power supply 240, the receiving end 220-3 of the RFIC 220, and/or the sending end 210-2 of the controller 210.

According to an embodiment, the diodes 701 and 703 may transmit the signal of a designated voltage and/or a designated power or more transmitted from the amplifier 235 to the controller 210, the RFIC 220, the amplifier 235, and/or the power supply 240. The signal may be added to the clock signal and/or the data signal transmitted from the controller 210. The signal added to the signal passing through diodes 701 and 703 can regulate the signal transmitted from the RFIC 220 to the amplifier 235. The signal added to the signal passing through diodes 701 and 703 can regulate the voltage applied to the amplifier 235 from the power supply 240.

As described above, the electronic device 101 can regulate the amplitude of the signal transmitted from the RFIC 220 to the amplifier 235, based on the signal passing through the diodes 701 and 703, thereby preventing damage (or burn-out) to the amplifier 235. The electronic device 101 can control the power supply 240 through the signals based on the diodes 701 and 703 to regulate an operating mode of the amplifier 235, thereby preventing damage to the amplifier.

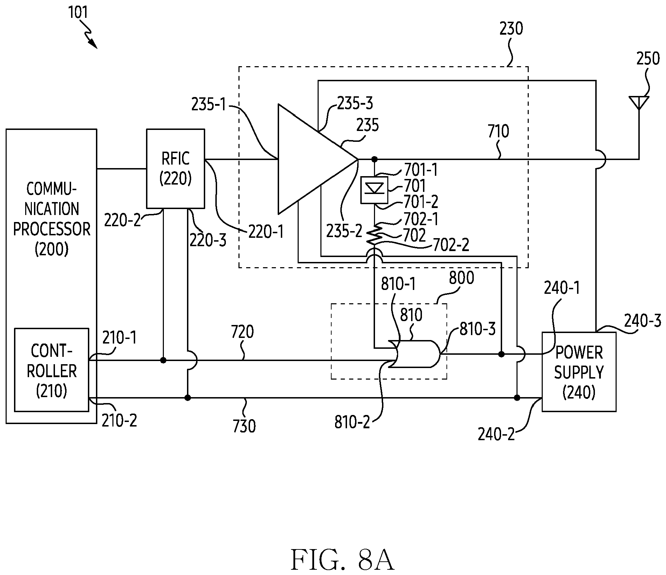

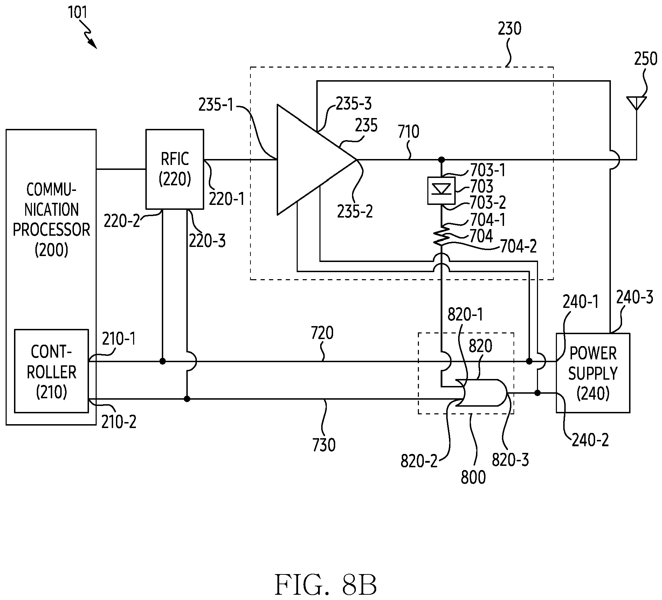

FIGS. 8A to 8C each illustrate an example of a circuit diagram of a portion of an RFFE included in an electronic device according to an embodiment. The electronic device 101 of FIGS. 8A to 8C may correspond to the electronic device 101 of FIGS. 1 to 7C. The communication processor 200 of FIGS. 8A to 8C may correspond to the communication processor 200 of FIGS. 2A to 7C. The RFFE 230 of FIGS. 8A to 8C may correspond to the RFFE 230 of FIGS. 2A to 7C. The controller 210 of FIGS. 8A to 8C may correspond to the controller 210 of FIGS. 2A to 7C. The RFIC 220 of FIGS. 8A to 8C may correspond to the RFIC 220 of FIGS. 2A to 7C. The power supply 240 of FIGS. 8A to 8C may correspond to the power supply 240 of FIGS. 2A to 7C. The antenna 250 of FIGS. 8A to 8C may correspond to the antenna 250 of FIGS. 2A to 7C. The diode 701 of FIGS. 8A to 8C may correspond to the diode 237 of FIGS. 2A to 2B and/or the diode 701 of FIGS. 7A to 7C. The diode 703 of FIGS. 8B to 8C may correspond to the diode 237 of FIGS. 2A to 2B and/or the diode 303 of FIGS. 7B to 7C.

Referring to FIGS. 8A to 8C, the electronic device 101 may include a communication processor 200, a controller 210, an RFIC 220, an RFFE 230, a logic circuit 800, a power supply 240, and/or an antenna 250. The RFFE 230 may include an amplifier 235, a diode 701, and a diode 703. Although FIGS. 8A to 8C show that the diode 701 and/or the diode 703 are shown in singular, they may be in plural.

According to an embodiment, the controller 210 may transmit the control signals (e.g., the clock signal and/or the data signal) to the RFIC 220. The RFIC 220 may operate based on reception of the control signals. According to an embodiment, the controller 210 may transmit the control signals to a controller in the amplifier 235. The amplifier 235 may operate based on the control signals received by the controller in the amplifier 235. For example, the amplifier 235 may amplify the radio frequency band signal transmitted from the RFIC 220, while receiving the control signals received by the controller in the amplifier 235. According to an embodiment, the controller 210 may transmit the control signals to the power supply 240. The power supply 240 may apply a voltage to the amplifier 235, based on reception of the control signals. The voltage applied to the amplifier 235 may include a voltage for amplifying the signal transmitted from the RFIC 220.

According to an embodiment, the RFFE 230 may further include a logic circuit 800. For example, a gate 810 and/or a gate 820 may be an example of the logic circuit 800. The logic circuit 800 may be arranged to prevent transmission of a signal obtained through the diode 701 to the signal path 720 between the controller 210 and the logic circuit 800.

According to an embodiment, the sending end 220-1 of the RFIC 220 may be connected to the receiving end 235-1 of the amplifier 235. The receiving end 220-2 of the RFIC 220 may be connected to the sending end 210-1 of the controller 210. The receiving end 220-3 of the RFIC 220 may be connected to the sending end 210-2 of the controller 210.

According to an embodiment, the amplifier 235 may be connected to the RFIC 220, the diodes 701 and 703, the power supply 240, and/or the antenna 250. The input terminal 235-1 of the amplifier 235 may be connected to the sending end 220-1 of the RFIC 220. The output terminal 235-2 of the amplifier 235 may be connected to the diodes 701 and 703 and/or to the antenna 250. The power input terminal 235-3 of the amplifier 235 may be connected to the output terminal 240-3 of the power supply 240.

Referring to FIG. 8A, according to an embodiment, the diode 701 may be connected to the amplifier 235, the antenna 250, and/or the resistor 702. The anode 701-1 of the diode 701 may be connected to the output terminal 235-2 of the amplifier 235 and/or to the antenna 250. The cathode 701-2 of the diode 701 may be connected to one end 702-1 of the resistor 702. The diode 701 may transmit the signal to the gate 810, based on receiving the signal transmitted from amplifier 235 having a designated power (e.g., 35.1 dBm) and/or a designated voltage (e.g., 5.1 V) or higher.

According to an embodiment, the resistor 702 may be connected to the diode 701 and/or the gate 810. One end 702-1 of the resistor 702 may be connected to the cathode 701-2 of the diode 701. The other end 702-2 of the resistor 702 may be connected to the input terminal 810-1 of the gate 810.

According to an embodiment, the gate 810 may be connected to the resistor 702, the controller 210, the RFIC 220, and/or the power supply 240. The input terminal 810-1 of the gate 810 may be connected to the other end 702-2 of the resistor. The input terminal 810-2 of the gate 810 may be connected to the sending end 210-1 of the controller 210 and/or the receiving end 220-2 of the RFIC 220. The gate 810 may transmit the signal indicating a digital value of 1 to the power supply 240, based on the signal transmitted through diode 701 being identified as the signal indicating a digital value of 1. For example, the clock signal transmitted from the controller 210 may be a continuation of the signal indicating a digital value of 0 and the signal indicating a digital value. The gate 810 may transmit the signal indicating a digital value of 1 to the power supply 240, based on the signal through diode 701 indicating a digital value of 1, while the clock signal indicates a digital value of 0.

Referring to FIG. 8B, according to an embodiment, a diode 703 may include an anode 703-1 connected to the amplifier 235 and the antenna 250, and a cathode 703-2 connected to one end 702-1 of the resistor 702. The resistor 704 may include one end 704-1 connected to the cathode 703-2 of the diode 703, and the other end 704-2 connected to the input terminal 820-2 of the gate 820. The diode 703 may perform substantially the same operation as the diode 701.

According to an embodiment, the gate 820 may be connected to the resistor 704, the controller 210, and/or the power supply 240. One input terminal 820-1 of the gate 820 may be connected to the other end 704-2 of the resistor 704. The other input terminal 820-2 of the gate 820 may be connected to the sending end 210-2 of the controller 210. The output terminal 820-3 of the gate 820 may be connected to the receiving end 240-2 of the power supply 240.

According to an embodiment, the gate 820 may transmit the signal indicating a digital value of 1 to the power supply 240, based on receiving the signal indicating a digital value of 1 transmitted from the diode 703. The power supply 240 may reduce the voltage applied to the amplifier 235, based on receiving the signal indicating a digital value of 1.

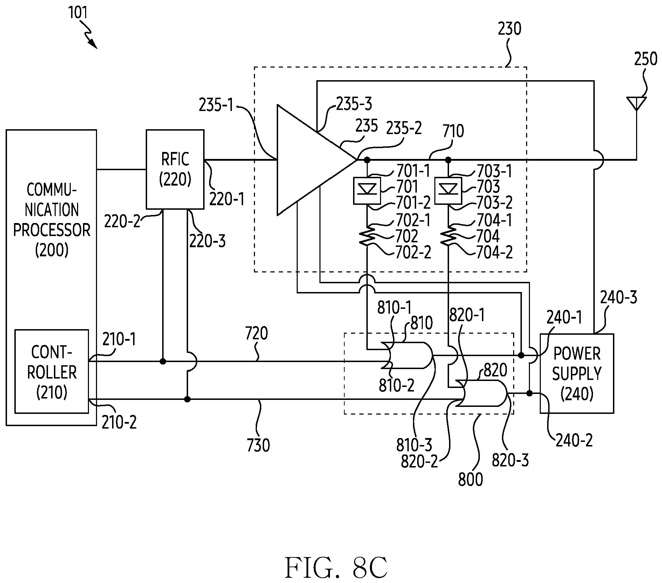

Referring to FIG. 8C, the RFFE 230 may include an amplifier 235, a diode 701, a resistor 702, a diode 703, a resistor 704, a gate 810, and/or a logic gate 820.

According to an embodiment, the diode 701 may be connected to the amplifier 235, the antenna 250, and/or the resistor 702. The diode 703 may be coupled to the amplifier 235, the antenna 250, and/or the resistor 704.

According to an embodiment, the gate 810 may transmit a signal for controlling the power supply 240 through the output terminal 810-3, based on the signal transmitted from the diode 701. The gate 820 may transmit the signal for controlling the power supply 240 through the output terminal 820-3, by means of a signal obtained based on the diode 703. For example, the signal for controlling the power supply 240 may include the signal indicating a digital value of 1.

According to an embodiment, the amplitude of the voltage applied from the power supply 240 to the amplifier 235 may be regulated based on receiving the signal indicating a digital value of 1 from the gate 810 and/or the gate 820. For example, the power supply 240 may regulate the voltage to amplify the amplitude of the signal transmitted from the RFIC 220 to the amplifier 235, based on the signal transmitted from the gate 810 and/or the gate 820. For example, based on at least one of the signals transmitted from the gate 810 or the gate 820 being the signal indicating a digital value of 1, the power supply 240 may apply the voltage to the amplifier 235, for amplifying a signal transmitted from the RFIC 220 to the amplifier 235. For example, based on the signals transmitted from the gate 810 and the gate 820 indicating a digital value of 0, the power supply 240 may apply a voltage within a range that does not amplify the signal transmitted from the RFIC 220 to the amplifier 235. For example, the power supply 240 may stop performing an operation, based on the signal indicating the digital value of 0.

As described above, the electronic device 101 may control the state of the power supply 240 independently of the RFIC 220, by means of the gate 810 and/or the gate 820. As described above, the electronic device 101 may control the voltage applied to the amplifier 235, by regulating the state of the power supply 240, based on the signals transmitted from the gate 810 and/or the gate 820. The electronic device 101 can prevent damage to the amplifier 235 by regulating the voltage applied to the amplifier 235.

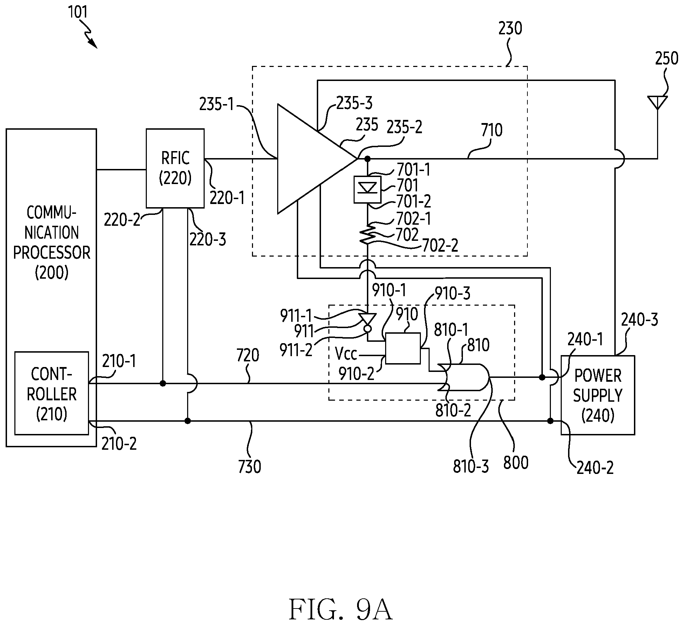

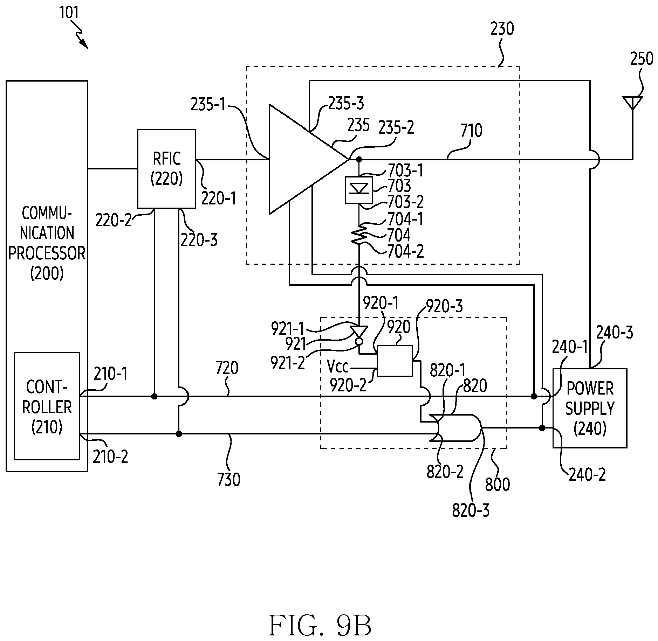

FIGS. 9A to 9C each illustrate an example of a circuit diagram of a portion of an RFFE included in an electronic device according to an embodiment. The electronic device 101 of FIGS. 9A to 9C may correspond to the electronic device 101 of FIGS. 1 to 8C. The communication processor 200 of FIGS. 9A to 9C may correspond to the communication processor 200 of FIGS. 2A to 8C. The RFFE 230 of FIGS. 9a to 9c may correspond to the RFFE 230 of FIGS. 2A to 8C. The controller 210 of FIGS. 9A to 9C may correspond to the controller 210 of FIGS. 2A to 8C. The RFIC 220 of FIGS. 9a to 9c may correspond to the RFIC 220 of FIGS. 2A to 8C. The power supply 240 of FIGS. 9A to 9C may correspond to the power supply 240 of FIGS. 2A to 8C. The antenna 250 of FIGS. 9A to 9C may correspond to the antenna 250 of FIGS. 2A to 8C. The diode 701 of FIGS. 9A to 9C may correspond to the diode 237 of FIGS. 2A to 2B and/or the diode 701 of FIGS. 7A to 8C. The Diode 703 of FIGS. 9B to 9C may correspond to the diode 237 of FIGS. 2A to 2B and/or the diode 703 of FIGS. 7B to 8C.

Referring to FIGS. 9A to 9C, the electronic device 101 may include a communication processor 200, a controller 210, an RFIC 220, an RFFE 230, a logic circuit 800, a power supply 240, and/or an antenna 250. The RFFE 230 may include an amplifier 235, a diode 701 and/or a diode 703. Although FIGS. 9A to 9C show that the diode 701 and/or the diode 703 are in singular, the disclosure is not limited thereto, and they may be in plural. Further, in FIGS. 9A to 9C, for example, a bistable circuit 910 and/or a bistable circuit 920 may include an SR latch and/or an SR flip-flop.

According to an embodiment, the logic circuit 800 may include a gate 810, a gate 820, an inverter 911, a bistable circuit 910, an inverter 921, and/or a bistable circuit 920. According to an embodiment, the bistable circuit 910 and/or the bistable circuit 920 may include an SR latch and/or an SR flip-flop.

Referring to FIG. 9A, the anode 701-1 of the diode 701 may be connected to the output terminal 235-2 of the amplifier 235. The cathode 701-2 of the diode 701 may be connected to one end 702-1 of the resistor 702. The other end 702-2 of the resistor 702 may be connected to the input terminal 911-1 of the inverter 911. An output terminal 911-2 of the inverter 911 may be connected to an input terminal 910-1 of the bistable circuit 910. A voltage may be applied to the bistable circuit 910 through another input terminal 910-2. The output terminal 910-3 of the bistable circuit 910 may be connected to the input terminal 810-1 of the gate 810. The input terminal 810-2 of the gate 810 may be connected to the sending end 210-1 of the controller 210 and/or the receiving end 220-2 of the RFIC 220. The output terminal 810-3 of the gate 810 may be connected to the receiving end 240-1 of the power supply 240. The receiving end 240-2 of the power supply 240 may be connected to the sending end 210-2 of the controller 210 and/or the receiving end 220-3 of the RFIC 220. The output terminal 240-3 of the power supply 240 may be connected to the power input terminal 235-3 of the amplifier 235.

Referring to FIG. 9B, the anode 703-1 of the diode 703 may be connected to the output terminal 235-2 of the amplifier 235. The cathode 703-2 of the diode 703 may be connected to one end 704-1 of the resistor 704. The other end 704-2 of the resistor 704 may be connected to the input terminal 921-1 of the inverter 921. An output terminal 921-2 of the inverter 921 may be connected to an input terminal 920-1 of the bistable circuit 920. A voltage may be applied to the bistable circuit 920 through another input terminal 920-2. The output terminal 920-3 of the bistable circuit 920 may be connected to the input terminal 820-1 of the gate 820. The input terminal 820-2 of the gate 820 may be connected to the sending end 210-2 of the controller 210 and/or the receiving end 220-3 of the RFIC 220. The output terminal 820-3 of the gate 820 may be connected to the receiving end 240-2 of the power supply 240. The receiving end 240-1 of the power supply 240 may be connected to the sending end 210-1 of the controller 210 and/or the receiving end 220-2 of the RFIC 220. The output terminal 240-3 of the power supply 240 may be connected to the power input terminal 235-3 of the amplifier 235.

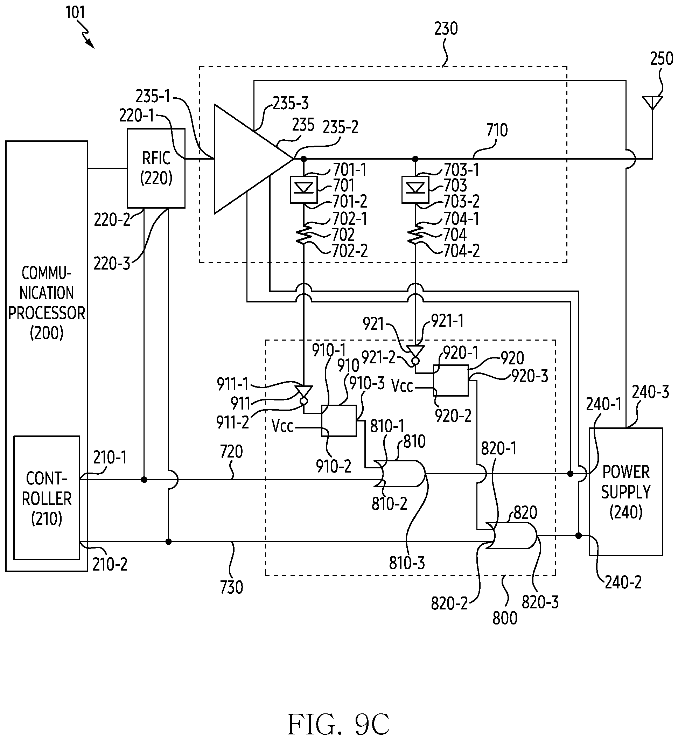

Referring to FIG. 9C, the anode 701-1 of the diode 701 may be connected to the output terminal 235-2 of the amplifier 235. The cathode 701-2 of the diode 701 may be connected to one end 702-1 of the resistor 702. The other end 702-2 of the resistor 702 may be connected to the input terminal 911-1 of the inverter 911. An output terminal 911-2 of the inverter 911 may be connected to an input terminal 910-1 of the bistable circuit 910. A voltage may be applied to the bistable circuit 910 through another input terminal 910-2. The output terminal 910-3 of the bistable circuit 910 may be connected to the input terminal 810-1 of the gate 810. The input terminal 810-2 of the gate 810 may be connected to the sending end 210-1 of the controller 210 and/or the receiving end 220-2 of the RFIC 220. The output terminal 810-3 of the gate 810 may be connected to the receiving end 240-1 of the power supply 240. The anode 703-1 of the diode 703 may be connected to the output terminal 235-2 of the amplifier 235. The cathode 703-2 of the diode 703 may be connected to one end 704-1 of the resistor 704. The other end 704-2 of the resistor 704 may be connected to the input terminal 921-1 of the inverter 921. An output terminal 921-2 of the inverter 921 may be connected to an input terminal 920-1 of the bistable circuit 920. A voltage may be applied to the bistable circuit 920 through another input terminal 920-2. The output terminal 920-3 of the bistable circuit 920 may be connected to the input terminal 820-1 of the gate 820. The input terminal 820-2 of the gate 820 may be connected to the sending end 210-2 of the controller 210 and/or the receiving end 220-3 of the RFIC 220. The output terminal 820-3 of the gate 820 may be connected to the receiving end 240-2 of the power supply 240. The output terminal 240-3 of the power supply 240 may be connected to the power input terminal 235-3 of the amplifier 235.

Referring to FIGS. 9A to 9C, the diodes 701 and 703 are configured to transmit the signal indicating a digital value of 1 to the bistable circuit 910 and/or the bistable circuit 920, based on the signal transmitted from the amplifier 235 being equal to or greater than a designated power (e.g., 35.1 dBm) and/or a designated voltage (e.g., 5.1 V). The inverters 911 and 921 may transmit the signal indicating a digital value of 0 to the bistable circuit 910 and/or the bistable circuit 920. The bistable circuit 910 and/or the bistable circuit 920 may receive the signal indicating a digital value of 1, based on a voltage being applied to the input terminal 920-2. The operation of the bistable circuit 910 and/or the bistable circuit 920 may be referred to the above Table 3.

According to an embodiment, the power supply 240 may be controlled based on a signal transmitted from the bistable circuit 910 and a clock signal transmitted from the controller 210. According to an embodiment, the power supply 240 may be controlled based on a signal transmitted from the bistable circuit 920 and a data signal transmitted from the controller 210. For example, the power supply 240 may transmit, to the amplifier 235, a voltage for amplifying the signal sent from RFIC 220 to the amplifier 235, based on the signals transmitted from the gate 810 and the gate 820 representing a digital value of 0. For example, the power supply 240 may apply to the amplifier 235 a voltage within a range that does not amplify the signal transmitted from the RFIC 220 to the amplifier 235, based on any one of the digital signal transmitted from the gate 810 or the digital signal transmitted from the gate 820 representing a digital value of 1.

As described above, the electronic device 101 can regulate the gain and/or state of the amplifier 235 based on the signal obtained through the bistable circuit 910 and/or the bistable circuit 920, thereby preventing damage (or burn-out) to the amplifier 235. As described above, the electronic device 101 can control the signal of the RFIC 220 independently of the state of the power supply 240, by allowing the bistable circuit 910 and/or the bistable circuit 920 to block transmission of the signals passing through the diodes 701 and 703 to the RFIC 220. Therefore, the electronic device 101 can prevent damage (or burn-out) of the amplifier 235 by means of controlling the signal of the RFIC 220.

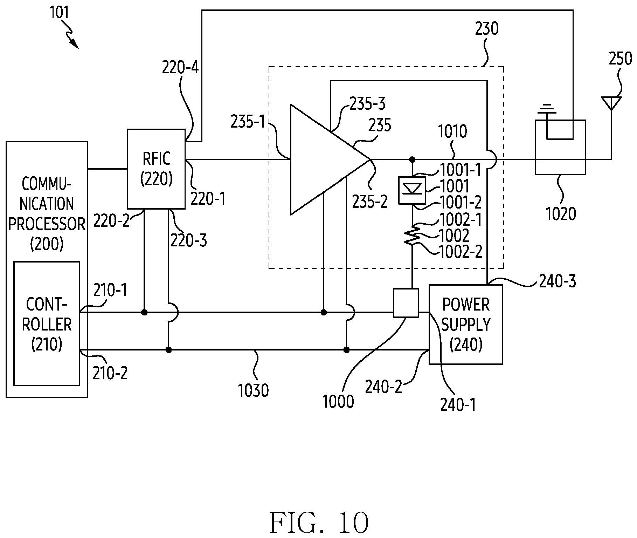

FIG. 10 illustrates an example of a circuit diagram of a portion of an RFFE included in an electronic device according to an embodiment. The electronic device 101 of FIG. 10 may correspond to the electronic device 101 of FIGS. 1 to 9C. The communication processor 200 of FIG. 10 may correspond to the communication processor 200 of FIGS. 2A to 9C. The RFFE 230 of FIG. 10 may correspond to the RFFE 230 of FIGS. 2A to 9C. The controller 210 of FIG. 10 may correspond to the controller 210 of FIGS. 2A to 9C. The RFIC 220 of FIG. 10 may correspond to the RFIC 220 of FIGS. 2A to 9C. The power supply 240 of FIG. 10 may correspond to the power supply 240 of FIGS. 2A to 9C. The antenna 250 of FIG. 10 may correspond to the antenna 250 of FIGS. 2A to 9C. A diode 1001 in FIG. 10 may correspond to the diode 237 in FIG. 2A, the diode 701 in FIGS. 7A to 9C, and/or the diode 703 in FIGS. 7B to 9C. Although in FIG. 10 the diodes 1001 illustrated in singular, it may be implemented in plural.

Referring to FIG. 10, according to an embodiment, the communication processor 200 may include a controller 210. The communications processor 200 may be operatively coupled to the RFIC 220. The communication processor 200 may transmit a signal for regulating the amplitude of the signal transmitted from the RFIC 220 to the amplifier 235. The communications processor 200 may cause a reset of the controller 210.

According to an embodiment, the sending end 210-1 of the controller 210 may be connected to the receiving end 220-2 of the RFIC 220, the resistor 1002, and/or the receiving end 240-1 of the power supply 240. According to an embodiment, the controller 210 may transmit a clock signal from the transmitter 210-1 through a signal path between the controller 210 and the power supply 240. According to an embodiment, the controller 210 may transmit a data signal from the sending end 210-1 through a signal path 1030 between the controller 210 and the power supply 240. The sending end 210-2 of the controller 210 may be connected to the receiving end 240-2 of the power supply 240.

According to an embodiment, the sending end 220-1 of the RFIC 220 may be connected to the input terminal 235-1 of the amplifier 235. The output terminal 235-2 of the amplifier 235 may be connected to the antenna 250 and/or to the anode 1001-1 of the diode 1001. The amplifier 235 may regulate the signal transmitted from RFIC 220 to transmit the regulated signal to the antenna 250 via the signal path 1010. For example, the amplifier 235 may amplify the signal transmitted from RFIC 220 and transmit the signal to the antenna 250 via the signal path 1010.

According to an embodiment, the anode 1001-1 of the diode 1001 may be connected to the signal path 1010. The cathode 1001-2 of the diode 1001 may be connected to one end 1002-1 of the resistor 1002. The other end 1002-2 of the resistor 1002 may be connected to the power supply 240, the controller 210, and/or the RFIC 220.

According to an embodiment, the receiving end 240-1 of the power supply 240 may be connected to the sending end 210-1 of the controller 210, the receiving end 220-2 of the RFIC 220, and/or to the other end 1002-2 of resistor 1002. The receiving end 240-2 of the power supply 240 may be connected to the sending end 210-2 of the controller 210 and/or the receiving end 220-3 of the RFIC 220. The output terminal 240-3 of the power supply 240 may be connected to the power input terminal 235-3 of the amplifier 235.

According to an embodiment, the signal having a designated power (e.g., 35.1 dBm) and/or a designated voltage (e.g., 5.1 V) or more, passing through the diode 1001, may be transmitted through the controller 210, the RFIC 220, and the amplifier. 235, and/or the power supply 240. The controller 210, the RFIC 220, the amplifier 235, and/or the power supply 240 may cease the operation based on the signal transmitted from diode 1001.

According to an embodiment, the coupler 1020 may obtain the signal on the signal path 1010 while a signal is transmitted from the amplifier 235 to the antenna 250. The signal obtained by the coupler 1020 may be smaller than the amplitude of the signal transmitted from the amplifier 235 to the antenna 250. The signal obtained by the coupler 1020 may be transmitted to a detector (e.g., a power detector) of the RFIC 220. According to an embodiment, the RFIC 220 may receive a signal obtained based on the coupler 1020, through the detection terminal 220-4. The signal obtained through the detection terminal 220-4 may be transmitted to the detector included in the RFIC 220 for identification. According to an embodiment, the detector may transmit a signal for causing a reset of the controller 210 to the communication processor 200, when the signal obtained from the coupler 1020 is maintained at a designated level. The controller 210 may, based on receiving the signal to cause the reset, transmit the clock signal and the data signal to the RFIC 220 and/or the power supply 240 to cause the RFIC 220 and/or the power supply 240 to initiate the operation.

According to an embodiment, the logic circuit 1000 may store a signal sent from the counter and/or the diode 1001. For example, the communications processor 200 may identify a signal transmitted from the diode 1001, the signal having the level below a designated power. The communication processor 200 may cause the controller 210 to reset, when the signal transmitted from the diode 1001 having the level less than the designated power is identified more than a designated number of times.

As described above, the electronic device 101 causes the controller 210 to be reset, based on the signal obtained through the coupler 1020. The electronic device 101 can cause the controller 210 interrupted by the signal obtained based on the diode 1001 to be reset based on the signal obtained through the coupler 1020.

A transmit signal having a higher power than a designate power level from a radio frequency integrated circuit (RFIC) may cause damage to an amplifier. An electronic device may then require a scheme for preventing damage (e.g., burn-out) of the amplifier by identifying a signal transmitted from the RFIC. To this end, an electronic device may transmit a signal from a signal path between an RFIC and an antenna to a signal path between a controller and a power supply, through a diode, in order to prevent damage to the amplifier.

As described above, according to an embodiment, an electronic device (e.g., an electronic device 101 of FIG. 1) includes a radio frequency integrated circuit (RFIC) (e.g., an RFIC 220 of FIG. 2A), a power amplifier (e.g., an amplifier 235 of FIG. 2A) connected to the RFIC via a first signal path (e.g., a signal path 310 in FIG. 3A), a power supply (e.g., a power supply 240 of FIG. 2A) for applying a voltage to the power amplifier, a controller (e.g., a controller 210 of FIG. 2A) connected to the power supply via a second signal path (e.g., a signal path 320 of FIG. 3A and/or a signal path 330 of FIG. 3B) different from the first signal path, and at least one diode (e.g., a diode 237 of FIG. 2a) including an anode (e.g., an anode 301-1 of diode 301 in FIG. 3A or an anode 303-1 of a diode 303 in FIG. 3B) connected to the first signal path and a cathode (e.g., a cathode 301-2 of a diode 301 in FIG. 3A or a cathode 303-2 of a diode 303 in FIG. 3B) connected to the second signal path. The RFIC may transmit a radio frequency band of radio signal via the first signal path to the power amplifier. The power supply may apply a voltage for amplifying amplitude of the radio signal to the power amplifier.

An electronic device according to various embodiments of the disclosure can prevent damage (e.g., burn-out) of an amplifier by means of identifying a signal transmitted from an RFIC. The electronic device can prevent damage to the amplifier by transmitting the signal through a diode from the signal path between the RFIC and the antenna to the signal path between the controller and the power supply.

For example, the electronic device further comprises a logic gate (e.g., a logic circuit 239 of FIG. 2B) including a first input terminal (e.g., an input terminal 410-1 of a gate 410 in FIG. 4A or an input terminal 420-1 of a gate 420 in FIG. 4B) connected to the cathode of the diode, and a second input terminal (e.g., an input terminal 410-2 of a gate 410 in FIG. 4A or an input terminal 420-2 of a gate 420 in FIG. 4B) connected to the second signal path. The logic gate may transmit, to the power supply, a third control signal obtained based on a first control signal input to the first input terminal and a second control signal input to the second input terminal.

For example, the RFIC may transmit a radio signal in a radio frequency band to the amplifier through the first signal path. The controller may transmit a control signal to the power supply at a designated period through the second signal path.

For example, the RFIC may transmit the radio signal in the radio frequency band to the amplifier through the first signal path. The controller may transmit a control signal for controlling an operation of the power supply to the power supply through the second signal path.

For example, the electronic device includes an inverter (e.g., an inverter 511 of FIG. 5A) including an input terminal (e.g., an input terminal 511-1 of the inverter 511 of FIG. 5A) connected to the cathode of the diode, and a latch (e.g., a bistable circuit 510 of FIG. 5A) including a first input terminal (e.g., an input terminal 510-1 of a bistable circuit 510 of FIG. 5A) connected to an output terminal of the inverter (e.g., an output terminal 511-2 of the inverter 511 of FIG. 5A), and a second input terminal (e.g., an input terminal 510-2 of the bistable circuit 510 of FIG. 5A) for receiving voltage. The latch may transmit a control signal to the power supply based on a voltage signal obtained by the diode and the voltage.

For example, the electronic device further comprises an antenna (e.g., an antenna 250 of FIG. 2A) for radiating the radio signal transmitted from the amplifier to an outside, and a coupler (e.g., a coupler 650 of FIG. 6) for obtaining at least a portion of the radio signal transmitted from the amplifier to the antenna. The RFIC may reset the controller based on the at least a portion of the radio signal obtained through the coupler.

For example, the electronic device further includes a register including a register (e.g., a resistor 302 of FIG. 3A or a resistor 304 of FIG. 3B) having one end (e.g., one end 302-1 of the resistor 302 of FIG. 3A or one end 304-1 of the resistor 304 of FIG. 3B) connected to the cathode of the diode, and the other end (e.g., the other end 302-2 of the resistor 302 of FIG. 3A or the other end 304-2 of the resistor 304 of FIG. 3B) connected to the second signal path.

For example, the power supply may be configured to be activated based on the control signal received from the controller via the second signal path, in a state in which the voltage applied to the first signal path is less than or equal to a threshold voltage of the diode.

For example, the power supply may be configured to perform an operation different from a control of the controller in a state in which the voltage applied to the first signal path exceeds the threshold voltage of the diode.

For example, the electronic device further comprises a second diode (e.g., a diode 303 of FIG. 3C) different from the diode, that is, a first diode, the second diode including an anode (e.g., an anode 303-2 of the diode 303 in FIG. 3C) connected to the first signal path and a cathode (e.g., a cathode 303-2 of the diode 303 of FIG. 3C) coupled between the second signal path and a third signal path different from the second signal path. The RFIC may be configured to transmit a radio signal in a radio frequency band to the amplifier through the first signal path. The controller may transmit a first control signal to the power supply at a predetermined period through the second signal path. The controller may be configured to transmit a second control signal for controlling an operation of the power supply to the power supply through the third signal path.

For example, the electronic device further comprises a first logic gate (e.g., a gate 410 of FIG. 4C) including a first input terminal (e.g., an input terminal 410-1 of the gate 410 of FIG. 4C) connected to the cathode of the first diode, a second input terminal (e.g., an input terminal 410-2 of the gate 410 in FIG. 4C) connected to the second signal path, and a first output terminal (e.g., an output terminal 410-3 of the gate 410 in FIG. 4C) connected to the power supply; and a second logic gate (e.g., a gate 420 of FIG. 4C) including a third input terminal (e.g., an input terminal 420-1 of the gate 420 of FIG. 4C) connected to the cathode of the second signal diode, a fourth input terminal (e.g., an input terminal 420-2 of the gate 420 of FIG. 4C) connected to the third signal path, and a second output terminal (e.g., an output terminal 420-3 of the gate 420 in FIG. 4C) connected to the power supply.

For example, the power supply may be configured to control a voltage applied to the amplifier, based on a first control signal transmitted from the first logic gate and a second control signal transmit from the second logic gate.

For example, the electronic device further comprises a first resistor (e.g., a resistor 302 in FIG. 3C) including one terminal (e.g., one end 302-1 of the resistor 302 of FIG. 3C) connected to the cathode of the first diode and another terminal (e.g., the other terminal 302-2 of resistor 302 of FIG. 3C) connected to the second signal path; and a second resistor (e.g., a resistor 304 of FIG. 3C) including one terminal (e.g., one end 304-1 of the resistor 304 of FIG. 3C) connected to the cathode of the second diode and another terminal (e.g., the other end 304-2 of the resistor 304 in FIG. 3C) connected to the second signal path.

For example, the electronic device further comprises an antenna for radiating the radio signal transmitted from the power amplifier to the outside, and a coupler for obtaining at least a portion of the radio signal transmitted from the power amplifier to the antenna. The RFIC may reset the controller based on the at least a portion of the radio signal obtained via the coupler.

For example, the electronic device further comprises a first inverter including an input terminal connected to the cathode of the first diode, a first latch including a first input terminal connected to an output terminal of the first inverter and a second input terminal for receiving a voltage, a second inverter including an input terminal connected to the cathode of the second diode, and a second bistable circuit including a third input terminal connected to an output terminal of the second inverter and a fourth input terminal for receiving a voltage.

As described above, according to an embodiment, an electronic device (e.g., an electronic device 101 of FIG. 1) comprises a radio frequency integrated circuit (RFIC) (e.g., an RFIC 220 of FIG. 2A), a power amplifier (e.g., an amplifier 235 of FIG. 2A) connected to the RFIC via a first signal path, a power supply (e.g., a power supply 240 of FIG. 2A) for applying a voltage to the power amplifier, a controller (e.g., a controller 210 of FIG. 2A) connected to the power supply via a second signal path different from the first signal path, an antenna (e.g., an antenna 250 of FIG. 2A) connected to the power amplifier via a third signal path (e.g., a signal path 710 of FIG. 7A), and at least one diode (e.g., a diode 701 of FIG. 7A or a diode 703 of FIG. 7B) including a cathode path (e.g., a cathode 701-2 of the diode 701 in FIG. 7A or a cathode 703-2 of the diode 703 in FIG. 7B) connected to the second signal path and an anode (e.g., an anode 701-1 of the diode 701 in FIG. 7A or an anode 703-1 of the diode 703 in FIG. 7B) connected to the third signal path.

For example, the electronic device further comprises a logic gate (e.g., a gate 810 of FIG. 8A or a gate 820 of FIG. 8B ) including a first input terminal (e.g., an input terminal 810-1 of a gate 810 of FIG. 8A or an input terminal 820-1 of a gate 820 of FIG. 8B) connected to the cathode of the diode, and a second input terminal (e.g., an input terminal 810-2 of the gate 810 of FIG. 8A or an input terminal 820-2 of the gate 820 of FIG. 8B) connected to the second signal path. The logic gate may transmit, to the power supply, a third control signal obtained based on a first control signal input to the first input terminal and a second control signal input to the second input terminal.

For example, the RFIC may transmit a radio signal of a radio frequency band to the power amplifier via the first signal path. The power amplifier may adjust amplitude of the radio signal transmitted from the RFIC and transmit to the antenna via the third signal path. The controller may transmit a control signal to the power supply at a designated period via the second signal path.

For example, the RFIC may transmit the radio signal of the radio frequency band to the power amplifier via the first signal path. The power amplifier may adjust amplitude of the radio signal transmitted from the RFIC and transmit to the antenna via the third signal path. The controller may transmit a control signal for controlling an operation of the power supply to the power supply via the second signal path.

For example, the electronic device further comprises (e.g., an inverter 911 of FIG. 9A) including an input terminal (e.g., an input terminal 911-1 of the inverter 911 of FIG. 9A) connected to the cathode of the diode, and a latch (e.g., a bistable circuit 910 of FIG. 9A) including a first input terminal (e.g., an input terminal 910-1 of the bistable circuit 910 of FIG. 9A) connected to an output terminal of the inverter (e.g., an output terminal 911-1 of the inverter 911 of FIG. 9A), and a second input terminal (e.g., an input terminal 910-2 of the bistable circuit 910 of FIG. 9A) for receiving a voltage. The latch may transmit a control signal to the power supply, based on a voltage signal obtained by the diode and the voltage.

For example, the electronic device further comprises a coupler (e.g., a coupler 1020 of FIG. 10) located in the third signal path. The RFIC may reset the controller based on at least a portion of the radio signal obtained via the coupler.

For example, the electronic device further comprises a resistor including one end connected to the cathode of the diode and the other end connected to the second signal path.

For example, the power supply may be activated based on a control signal received from the controller via the second signal path, in a state in which a voltage applied to the first signal path is less than or equal to a threshold voltage of the diode.

For example, the power supply may be deactivated based on the control signal received from the controller via the second signal path in a state in which the voltage applied to the first signal path exceeds the threshold voltage of the diode.

For example, the electronic device further comprises a second diode different from the diode, that is, a first diode, including an anode connected to the third signal path and an anode coupled between the third signal path and a fourth signal path different from the third signal path. The RFIC may transmit the radio signal of the radio frequency band to the amplifier via the first signal path. The controller may transmit a first control signal to the power supply at a designated period via the second signal path. The controller may transmit a second control signal for controlling an operation of the power supply to the power supply via the fourth signal path.

For example, the electronic device further comprises a first logic gate including a first input terminal connected to the cathode of the first diode, a second input terminal connected to the second signal path, and a first output terminal connected to the power supply, and a second logic gate including a third input terminal connected to the cathode of the second diode, a fourth input terminal connected to the fourth signal path, and a second output terminal connected to the power supply.

For example, the power supply the power supply may control a voltage applied to the power amplifier, based on a first control signal transmitted form the first logic gate and a second control signal transmitted from the second logic gate.

For example, the electronic device further comprises a first resistor including one terminal connected to the cathode of the first diode and another terminal connected to the second signal path, and a second resistor including one terminal connected to the cathode of the second diode and another terminal connected to the second signal path.

For example, the electronic device further comprises a coupler for obtaining at least a portion of the radio signal transmitted from the power amplifier to the antenna. The RFIC may reset the controller based on the at least a portion of the radio signal obtained via the coupler.

For example, the electronic device further comprises a first inverter including an input terminal connected to the cathode of the first diode, a first latch circuit including a first input terminal connected to an output terminal of the first inverter and a second input terminal for receiving a voltage, a second inverter including an input terminal connected to the cathode of the second diode, and a second latch circuit including a third input terminal connected to an output terminal of the second inverter and a fourth input terminal for receiving a voltage.

The electronic device according to various embodiments of the disclosure may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the disclosure and the terms used therein are not intended to limit the technological features set forth herein to particular embodiments and include various changes, equivalents, or replacements for a corresponding embodiment of the disclosure. With regard to the description of the drawings, similar reference numerals may be used to refer to similar or related elements. As used herein, each of such phrases as "A or B", "at least one of A and B", "at least one of A or B", "A, B, or C", "at least one of A, B, and C", and "at least one of A, B, or C" may include any one of, or all possible combinations of the items enumerated together in a corresponding one of the phrases. As used herein, such terms as "1st" and "2nd", or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with", "coupled to", "connected with", or "connected to" another element (e.g., a second element), it means that the element may be coupled with the other element directly (e.g., wired), wirelessly, or via a third element.

As used herein, the term "module" may include a unit implemented in hardware, software, or firmware, and may interchangeably be used with other terms, for example, "logic", "logic block", "part", or "circuitry". A module may be a single integral component, or a minimum unit or part thereof, adapted to perform one or more functions. For example, according to an embodiment of the disclosure, the module may be implemented in a form of an application-specific integrated circuit (ASIC).

Various embodiments as set forth herein may be implemented as software (e.g., the program 140) including one or more instructions that are stored in a storage medium (e.g., an internal memory 136 or an external memory 138) that is readable by a machine (e.g., the electronic device 101). For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a compiler or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., a compact disc read only memory (CD-ROM)), or be distributed (e.g., downloaded or uploaded) online via an application store (e.g., PlayStore^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

## Claims

1. An electronic device comprising:
a radio frequency integrated circuit (RFIC) (220);
a power amplifier (235) connected to the RFIC (220) via a first signal path;
a power supply (240) for applying a voltage to the power amplifier (235);
a controller (210) connected to the power supply (240) via a second signal path different from the first signal path; and
a first diode comprising an anode connected to the first signal path and a cathode connected to the second signal path;
wherein the RFIC (220) is configured to transmit a radio signal of a radio frequency band through the first signal path to the power amplifier (235);
wherein the power supply (240) is configured to apply a voltage to the power amplifier (235) for amplifying an amplitude of the radio signal transmitted from the RFIC (220).

2. The electronic device of claim 1, further comprising:
a logic gate including a first input terminal connected to the cathode of the first diode and a second input terminal connected to the second signal path;
wherein the logic gate is configured to transmit, to the power supply, a third control signal obtained based on a first control signal input to the first input terminal and a second control signal input to the second input terminal.

3. The electronic device of any one of the preceding claims, wherein the controller is configured to transmit a control signal to the power supply at a designated period via the second signal path.

4. The electronic device of claim 3, wherein the controller is configured to transmit the control signal for controlling an operation of the power supply to the power supply via the second signal path.

5. The electronic device of any one of claim 3 or 4, further comprising:
an inverter including an input terminal connected to the cathode of the first diode; and
a bistable circuit including a first input terminal connected to an output terminal of the inverter and a second input terminal for receiving a voltage,
wherein the bistable circuit is configured to transmit a control signal to the power supply based on a voltage signal obtained by the first diode and the voltage.

6. The electronic device of any one of the preceding claims, further comprising:
an antenna for radiating the amplified radio signal from the power amplifier to an outside; and
a coupler, disposed between the antenna and the power amplifier, for obtaining at least a portion of the amplified radio signal from the power amplifier;
wherein the RFIC is configured to reset the controller based on the at least a portion of the radio signal obtained via the coupler.

7. The electronic device of any one of the preceding claims, further comprising a resistor including one terminal connected to the cathode of the first diode and another terminal connected to the second signal path.

8. The electronic device of any one of claims 3-7, wherein the power supply is configured to be activated based on the control signal received from the controller via the second signal path, in a state in which the voltage applied to the first signal path is less than or equal to a threshold voltage of the first diode.

9. The electronic device of claim 1, wherein the power supply is configured to perform an operation different from a control of the controller in a state in which the voltage applied to the first signal path exceeds the threshold voltage of the first diode.

10. The electronic device of claim 1, further comprising a second diode different from the first diode, the second diode including an anode connected to the first signal path and a cathode coupled between the second signal path and a third signal path different from the second signal path;
wherein the RFIC is configured to transmit the radio signal of the radio frequency band to the power amplifier via the first signal path; and
wherein the controller is further configured to:
transmit a first control signal to the power supply at a designated period via the second signal path;
transmit a second control signal for controlling the operation of the power supply to the power supply via the third signal path.

11. The electronic device of claim 10, further comprising:
a first logic gate including a first input terminal connected to the cathode of the first diode, a second input terminal connected to the second signal path, and a first output terminal connected to the power supply; and
a second logic gate including a third input terminal connected to the cathode of the second signal diode, a fourth input terminal connected to the third signal path, and a second output terminal connected to the power supply.

12. The electronic device of claim 11, wherein the power supply is configured to control a voltage applied to the amplifier, based on a first control signal transmitted from the first logic gate and a second control signal transmit from the second logic gate.

13. The electronic device of any one of claims 10-12, further comprising:
a first resistor including one terminal connected to the cathode of the first diode and another terminal connected to the second signal path; and
a second resistor including one terminal connected to the cathode of the second diode and another terminal connected to the second signal path.

14. The electronic device of any one of claims 10-13, further comprising:
an antenna for radiating the amplified radio signal from the power amplifier to the outside; and
a coupler, disposed between the antenna and the power amplifier for obtaining at least a portion of the amplified radio signal from the power amplifier ;
wherein the RFIC is configured to reset the controller based on the at least a portion of the radio signal obtained via the coupler.

15. The electronic device of any one of claims 10-14, further comprising:
a first inverter including an input terminal connected to the cathode of the first diode;
a first bistable circuit including a first input terminal connected to an output terminal of the first inverter and a second input terminal for receiving a voltage;
a second inverter including an input terminal connected to the cathode of the second diode; and
a second bistable circuit including a third input terminal connected to an output terminal of the second inverter and a fourth input terminal for receiving a voltage.
